# EUROPEAN PATENT SPECIFICATION

(11) **EP 2 963 436 B1**
(45) Date of publication and mention of the grant of the patent: **27.12.2017**
(21) Application number: 13866027.9
(22) Date of filing: 28.11.2013
(51) Int. Cl.: G01R 33/09, G01R 33/00

(54) **MAGNETIC SENSING DEVICE AND MAGNETIC SENSING METHOD THEREFOR**
VORRICHTUNG ZUR MAGNETISCHEN ABTASTUNG UND VERFAHREN ZUR MAGNETISCHEN ABTASTUNG DAFÜR
DISPOSITIF DE DÉTECTION MAGNÉTIQUE ET PROCÉDÉ DE DÉTECTION MAGNÉTIQUE POUR CELUI-CI

(30) Priority: 21.12.2012 CN 201210563956
(43) Date of publication of application: 06.01.2016
(73) Proprietor: QST Corporation, Shanghai 200050 (CN)
(72) Inventor: WAN, Hong, Shanghai 200050 (CN); WAN, Xudong, Shanghai 200050 (CN); ZHANG, Ting, Shanghai 200050 (CN)
(74) Representative: Awapatent AB
(86) International application number: PCT/CN2013/088048
(87) International publication number: WO 2014/094526

(56) References cited:
- WO-A1-2011/123454
- WO-A1-2012/085296
- CN-A- 101 290 343
- CN-A- 101 813 479
- CN-A- 102 385 043
- CN-A- 102 426 344
- CN-U- 202 149 936
- JP-A- 2004 006 752
- JP-A- 2009 216 390
- US-A1- 2005 270 020
- US-A1- 2011 244 599

## Description

### FIELD OF THE INVENTION

The present invention belongs to a technical field of electrical communication, refers to a magnetic sensing apparatus, and more particularly to a magnetic three-axis sensing apparatus in a single chip. The present invention also refers to a magnetic sensing method of the magnetic sensing apparatus above.

### BACKGROUND OF THE INVENTION

Magnetic sensor is divided by its principle into hall component, magnetic sensing diode, anisotropic magneto-resistance (AMR) component, tunneling magneto-resistance (TMR) component, giant magneto-resistance (GMR) component, induction coil, and superconductive quantum interference magnetometer.

Electrical compass is one of important application field to magnetic sensor. With rapid development of consumer electronics in recent years, more and more smart phones and panel computers assemble electrical compass beside of navigation system, and it makes users feel very convenience. The magnetic sensor developed from two axis to three axis in recent years. Two-axis magnetic sensor, that is to say plane magnetic sensor, can measure magnetic field strength and direction in a plane illustrated by X and Y-axis.

Operating principle of the magnetic sensor in prior art is shown as below. Anisotropic magneto-resistance material is used in the magnetic sensor to measure the magnetic induction strength in a space. Alloy material with crystal structure adopted here is very sensitive to outside magnetic field, and variation of magnetic field lead to variation of resistance of AMR.

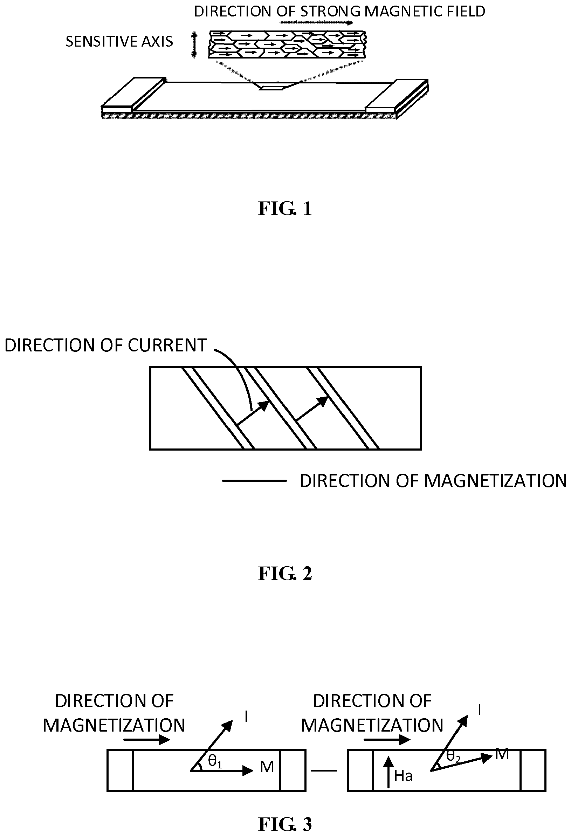

A strong magnetic field is added on an AMR unit to magnetize it in one direction in preparation and application. Then a primary magnetic field is built, and an axis perpendicular to the primary magnetic field is named as sensitive axis of the AMR unit, as illustrated in Fig. 1. Metal wires on the AMR material are canted with 45° to make the measurement result variation linearly, and current flow in these wires and AMR material, as illustrated in Fig.2. Angle between the primary magnetic field in the AMR material built by the initial strong magnetic field and the current is 45°.

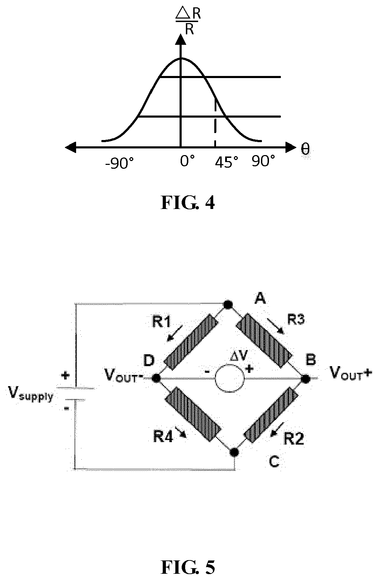

When outside magnetic field Ha exists, direction of the primary magnetic field in AMR unit varies and is not the initial direction, and then angel θ between direction M of magnetic field and current I varies as illustrated in Fig.3. The variation of θ dues to resistance variation of AMR, as that illustrated in Fig.4.

The outside magnetic field can be measured by measuring the resistance variation of AMR unit. In real application, a Wheatstone bridge or half Wheatstone bridge in the magnetic sensor is used for measuring the resistance variation of AMR, in order to improve sensitivity of the component, as illustrated in Fig.5. R1/R2/R3/R4 are ARM resistors with same initial state. When outside magnetic field is detected, the resistances of R1/R2 increase ΔR, and these of R3/R4 reduce ΔR. So the output of bridge is zero when outside magnetic field does not exist; and the output of bridge is a small voltage ΔV when outside magnetic field exists.

A sensing part in a plane (two-axis X, and Y) and a sensing part for Z direction are packaged together in system level to realize triaxial sensing for three-axis sensor in prior art. That is to say, the sensing part in the plane and the sensing part for Z direction are set in two independent wafer or chip, and assembled together by packing. Triaxial sensing in a single wafer/chip in the prior art is disclosed in WO 2012/085296 A1 (ST MICROELECTRONICS SRL [IT]; PACI DARIO [IT]; MORELLI MARCO [IT]; RIV, 28 June 2012) and US 2011/244599 A1 (WHIG RENU [US] ET AL, 6 October 2011). So, a new magnetic sensing apparatus is needed in the prior art, to produce a three-axis sensor in a single wafer/chip.

### SUMMARY OF THE INVENTION

In the present invention, in order to solve technical problem, a magnetic sensing apparatus is provided. X-axis, Y-axis, and Z-axis sensing components are set in a single wafer or chip, which has outstanding performance.

Additionally, a magnetic sensing method of the magnetic sensing apparatus above is provided. Magnetic data in X-axis, Y-axis, and Z-axis can be induced according the sensing components in the single wafer or chip.

To solve the technical problem above, a technical proposal is provided in the present invention:
A magnetic sensing apparatus comprising a third direction magnetic sensing component, and the third direction magnetic sensing component comprises a substrate and a pair of coupled magnetic sensing modules, a groove is set in surface of the substrate; and
the magnetic sensing module comprises:
   a magnetic conductive unit, main part of the magnetic conductive unit is set in the groove, and a part of it is exposed out the groove and to surface of the substrate, in order to collect magnetic field signal in the third direction and output the magnetic field signal, the magnetic conductive unit comprises a magnetic material layer; and
   an inducing unit setting on the surface of the substrate, to receive the magnetic field signal in the third direction and measure corresponding magnetic field strength in the third direction by the magnetic field signal; the inducing unit comprises a magnetic material layer, electrical resistance of the magnetic material in the magnetic material layer is variable with the magnetic field strength and direction; and
output magnetic signals in a first direction or/and a second direction for every pairs of coupled magnetic sensing modules can be offset, after the corresponding pair of coupled magnetic sensing modules is settled.

As an optimized embodiment of the present invention, the third direction magnetic sensing component is a perpendicular direction magnetic sensing component;
the magnetic conductive unit is used for collecting the magnetic field signal in the perpendicular direction and output the magnetic signal;
the inducing unit is a magnetic sensor inducing magnetic field paralleled to the surface of the substrate, sets on the surface of the substrate, used for receiving the magnetic field signal in the perpendicular direction output by the magnetic conductive unit, and measuring corresponding magnetic field strength in the perpendicular direction by the magnetic field signal; and
the magnetic sensing apparatus further comprises a first magnetic sensor, and a second magnetic sensor, in order to induce magnetic field in the first direction, and the second direction respectively. The first direction and the second direction are perpendicular.

As an optimized embodiment of the present invention, the magnetic sensing apparatus further comprises a first magnetic sensor, and a second magnetic sensor, in order to induce magnetic field in the first direction, and the second direction respectively. The first direction, the second direction, and the third direction are perpendicular each other.

As an optimized embodiment of the present invention, each pair of coupled magnetic sensing modules comprises three factors
(1) the relative locations of the groove and the inducing unit; the groove set in one side of the corresponding inducing unit, or other side; the magnetic conductive unit is at left of the inducing unit, to guide the magnetic field in the third direction to one direction in the surface of the substrate, and the magnetic conductive unit is at right of the inducing unit, to guide the magnetic field in the third direction to other direction in the surface of the substrate;
(2) the inducing unit gets an initial magnetization direction by outer exciting magnetic field; and the initial magnetization directions of the two magnetic sensing modules are set as same or opposite; and
(3) direction of current in the magnetic sensing module; the directions of current in the two magnetic sensing modules are set as same or orthographic.

For each of the coupled two magnetic sensing modules, the first factors in the three factors are set as opposite, and the other two are set as same; or all the factors are set as opposite.

Comparison of the two magnetic sensing modules above is based on the two magnetic sensing modules are paralleled; so called paralleled is that the magnetic material layers of the inducing units in the two magnetic sensing modules above have same or opposite magnetization direction, and direction of the grooves in the two magnetic sensing modules are parallel or overlap;
As an optimized embodiment of the present invention, each pair of the coupled two magnetic sensing modules above is paralleled, that is to say initial magnetization directions of the magnetic material layer in the inducing unit of the two magnetic sensing module are same or opposite.

As an optimized embodiment of the present invention, each magnetic sensing modules above is paralleled, and the first factors are set as opposite and the other two factors are set as same for the three factors of the two connected magnetic sensing modules; or all the factors are set as opposite.

As an optimized embodiment of the present invention, the third direction magnetic sensing component comprises a first magnetic sensing module, a second magnetic sensing module, a third magnetic sensing module, and a fourth magnetic sensing module;
each magnetic sensing modules above is paralleled, that is to say initial magnetization directions of the magnetic material layer in the sensing units of the two magnetic sensing module are same or opposite, and trends of the grooves in the magnetic sensing modules are paralleled or overlapped;
a first terminal of the first magnetic sensing module and a second terminal of the first magnetic sensing module are grounding, a second terminal of the first magnetic sensing module connects to the a first terminal of the fourth magnetic sensing module, a second terminal of the second magnetic sensing module connects to the a first terminal of the third magnetic sensing module; a second terminal of the third magnetic sensing module and a second terminal of the fourth magnetic sensing module connect to a power source, and an electrical signal is output between a second terminal of the first magnetic sensing module and a second terminal of the second magnetic sensing module;
the grooves coupled to each part of the inducing unit are set in a first side of the coupled part of the inducing unit in the first magnetic sensing module; initial magnetization direction of the magnetic material layer in the inducing unit is direction A, and current is direction B;
the grooves coupled to each part of the inducing unit are set in a second side of the coupled part of the inducing unit in the second magnetic sensing module; initial magnetization direction of the magnetic material layer in the inducing unit is a direction opposite to the direction A, and current is a direction perpendicular to the direction B;
the grooves coupled to each part of the inducing unit are set in a first side of the coupled part of the inducing unit in the third magnetic sensing module; initial magnetization direction of the magnetic material layer in the inducing unit is a direction same to the direction A, and current is a direction paralleled to the direction B;
the grooves coupled to each part of the inducing unit are set in a second side of the coupled part of the inducing unit in the fourth magnetic sensing module; initial magnetization direction of the magnetic material layer in the inducing unit is a direction opposite to the direction A, and current is a direction perpendicular to the direction B.

As an optimized embodiment of the present invention, the third direction magnetic sensing component comprises a first magnetic sensing module, a second magnetic sensing module, a third magnetic sensing module, and a fourth magnetic sensing module;
each magnetic sensing modules above is paralleled, that is to say initial magnetization directions of the magnetic material layer in the inducing unit of the two magnetic sensing module are same or opposite, and trends of the grooves in the magnetic sensing modules are paralleled or overlapped;
a first terminal of the first magnetic sensing module and a first terminal of the second magnetic sensing module are grounding, a second terminal of the first magnetic sensing module connects to the a first terminal of the fourth magnetic sensing module, a second terminal of the second magnetic sensing module connects to the a first terminal of the third magnetic sensing module; a second terminal of the third magnetic sensing module and a second terminal of the fourth magnetic sensing module connect to a power source, and an electrical signal is output between a second terminal of the first magnetic sensing module and a second terminal of the second magnetic sensing module;
the grooves coupled to each part of the inducing unit are set in a first side of the coupled part of the inducing unit in the first magnetic sensing module; initial magnetization direction of the magnetic material layer in the inducing unit is direction A, and current is direction B;
the grooves coupled to each part of the inducing unit are set in a second side of the coupled part of the inducing unit in the second magnetic sensing module; initial magnetization direction of the magnetic material layer in the inducing unit is a direction same to the direction A, and current is a direction paralleled to the direction B;
the grooves coupled to each part of the inducing unit are set in a first side of the coupled part of the inducing unit in the third magnetic sensing module; initial magnetization direction of the magnetic material layer in the inducing unit is a direction same to the direction A, and current is a direction paralleled to the direction B;
the grooves coupled to each part of the inducing unit are set in a second side of the coupled part of the inducing unit in the fourth magnetic sensing module; initial magnetization direction of the magnetic material layer in the inducing unit is a direction same to the direction A, and current is a direction paralleled to the direction B.

As an optimized embodiment of the present invention, the third direction magnetic sensing component comprises a first magnetic sensing module, a second magnetic sensing module, a third magnetic sensing module, and a fourth magnetic sensing module;
center points of the first magnetic sensing module and the second magnetic sensing module are in the same line, that is to say magnetization directions of the magnetic material layer in the inducing unit of the first magnetic sensing module and the second magnetic sensing module are same or opposite, and trends of the grooves in the magnetic sensing modules are paralleled or overlapped;
the third magnetic sensing module and the fourth magnetic sensing module are respectively perpendicular to the first magnetic sensing module and the second magnetic sensing module, that is to say initial magnetization directions of the magnetic material layer in the inducing unit of the third magnetic sensing module and the fourth magnetic sensing module are respectively perpendicular to the first magnetic sensing module and the second magnetic sensing module, and trends of the grooves in the third magnetic sensing module and the fourth magnetic sensing module are respectively perpendicular to trend of the corresponding grooves in the first magnetic sensing module and the second magnetic sensing module;
a first terminal of the first magnetic sensing module and a first terminal of the second magnetic sensing module are grounding, a second terminal of the first magnetic sensing module connects to the a first terminal of the fourth magnetic sensing module, a second terminal of the second magnetic sensing module connects to the a first terminal of the third magnetic sensing module; a second terminal of the third magnetic sensing module and a second terminal of the fourth magnetic sensing module connect to a power source, and an electrical signal is output between a second terminal of the first magnetic sensing module and a second terminal of the second magnetic sensing module;
for the coupled first magnetic sensing module and the second magnetic sensing module, the relative location of the groove and the inducing units for them are set as opposite, and the initial magnetization directions and the current directions are set as same in the three factors; or the relative location of the groove and the inducing units for them are set as opposite, the initial magnetization directions set as opposite, and the current directions are perpendicular;
for the coupled third magnetic sensing module and the fourth magnetic sensing module, the relative location of the groove and the inducing units for them are set as opposite, and the initial magnetization directions and current directions are set as same in the three factors; or the relative location of the groove and the inducing units for them are set as opposite, the initial magnetization directions set as opposite, and the current directions are perpendicular.

As an optimized embodiment of the present invention, the third direction magnetic sensing component comprises a peripheral circuit, used for calculating magnetic field strength and magnetic field direction, and outputting;
angle between main part of the magnetic conductive unit and surface of the substrate is 45°∼90°; the inducing unit is appressed to the surface of the substrate, and paralleled to the surface of the substrate;
the first direction is X-axis, the second direction is Y-axis, and the third direction is Z-axis.

As an optimized embodiment of the present invention, the apparatus further comprises a second magnetic sensing component, used for sensing magnetic signal in the first direction or/and the second direction, and measuring the corresponding magnetic field strength and magnetic field direction in the first direction or/and the second direction by it.

As an optimized embodiment of the present invention, the second magnetic sensing component comprises four inducing subunits, which are a fifth inducing subunit, a sixth inducing subunit, a seventh inducing subunit, and an eighth inducing subunit;
each inducing subunit above comprises a magnetic material layer, electrical resistance of magnetic material in the magnetic material layer is variable depending on the magnetic field strength and direction; and angle between direction of setting the electrical node and direction of magnetization in the magnetic material layer is 10°∼80°.

As an optimized embodiment of the present invention, the magnetic conductive unit comprises four magnetic conductive subunits, which are a first magnetic conductive subunit, a second magnetic conductive subunit, a third magnetic conductive subunit, and a fourth magnetic conductive subunit;
the inducing unit comprises four inducing subunits, which are a first inducing subunit, a second inducing subunit, a third inducing subunit, and a fourth inducing subunit;
the first magnetic conductive subunit is coupled with the first inducing subunit as the first inducing module of the magnetic sensing component in the third direction;
the second magnetic conductive subunit is coupled with the second inducing subunit as the second inducing module of the magnetic sensing component in the third direction;
the third magnetic conductive subunit is coupled with the third inducing subunit as the third inducing module of the magnetic sensing component in the third direction;
the fourth magnetic conductive subunit is coupled with the fourth inducing subunit as the fourth inducing module of the magnetic sensing component in the third direction;
each inducing subunit above comprises a magnetic material layer, electrical resistance of magnetic material in the magnetic material layer is variable depending on the magnetic field strength and direction, multiple paralleled electrical nodes are set on the magnetic material layer; angle between direction of setting the electrical node and direction of magnetization in the magnetic material layer is 10°∼80°;
the magnetic conductive unit and the inducing unit comprise magnetic material layers respectively; material of the magnetic material layer is magneto-resistance material, anisotropic magneto-resistance (AMR) material, giant magneto-resistance (GMR) material, or tunneling magneto-resistance (TMR) material; character of them is that electrical resistivity of the material is variable depending on variation of magnetic field.

Principle of the magnetic sensing apparatus is anisotropic magneto-resistance (AMR), giant magneto-resistance (GMR), or tunneling magneto-resistance (TMR).

One or multiple columns of grooves are set in the substrate, and a column of grooves is formed by a long and narrow groove, or a column of grooves comprises multiple sub-grooves.
each magnetic conductive subunit comprises multiple magnetic accessories, main part of the magnetic accessory is set in the corresponding groove, and a part of it is exposed out of the groove; and the exposed part is appressed to the magnetic material layer of the corresponding inducing subunit;
each magnetic accessory has the exposed part out of the groove, and distance between the exposed part and the magnetic material layer of the corresponding inducing subunit is 0-20 micrometers.

As an optimized embodiment of the present invention, the magnetic conductive unit and the magnetic material layer of the inducing unit are formed by same magnetic material, and have same number of layers deposited in same step; the magnetic conductive unit and the magnetic material layer of the inducing unit are formed by different magnetic material deposited in different steps.

A magnetic induction method using the magnetic sensing apparatus above comprises the step of inducing magnetic field in third direction, and specifically comprises:
a magnetic conductive unit collects magnetic signal in the third direction, and outputs the magnetic signal;
an inducing unit receives the magnetic signal in the third direction output by the magnetic conductive unit, and measure the magnetic field strength and magnetic field direction corresponding to the third direction by the magnetic signal;
each pair of magnetic sensing modules can directly offset the output magnetic field signal in first or/and second direction of the pair of magnetic sensing modules, after setup of each pair of magnetic sensing modules in the magnetic sensing apparatus is complete.

As an optimized embodiment of the present invention, the method further comprises the inducing step in the first direction and the second direction. Induce the magnetic signal in the first direction and the second direction, and measure the magnetic field strength and magnetic field direction corresponding to the first direction and the second direction by them.

The advantage of the present invention is that, an inducing unit with X, Y, and Z-axis direction in a single wafer/chip is provided in the magnetic sensing apparatus and the magnetic induction method provided in the present invention, and the peripheral ASIC circuit is integrated optionally on the single chip using fully compatible process with standard CMOS process; and it is easy to product, has outstanding performance, and has competitive price. In the present invention, the magnetic signals in X-axis, Y-axis, and Z-axis can be measured independently, after setup of each two coupled magnetic sensing modules is complete

### DESCRIPTION OF FIGURES

Fig.1 is schematic diagram for magnetic material of magnetic sensing apparatus in the prior art.
Fig.2 is schematic diagram for structure of the magnetic material and wire of the magnetic sensing apparatus in the prior art.
Fig.3 is schematic diagram for angle between magnetic direction and current direction.
Fig.4 is schematic diagram for θ-R characterization curve of the magnetic material.
Fig.5 is diagram for a wheatstone bridge.
Fig.6 is top view diagram for a part of the magnetic sensing apparatus in the present invention.
Fig.7 is section view diagram for the Fig.1 along A-A direction.
Fig. 8 is schematic diagram for structure of the magnetic sensing apparatus in the present invention.
Fig.9 is top view diagram for a part of the magnetic sensing apparatus in the six embodiment.
Fig.10 is schematic diagram for structure of the magnetic sensing apparatus of the present invention in the second embodiment.
Fig. 11 is schematic diagram for structure of the magnetic sensing apparatus of the present invention in the third embodiment.
Fig. 12 is schematic diagram for structure of the magnetic sensing apparatus of the present invention in the fourth embodiment.
Fig. 13 is schematic diagram for structure of the magnetic sensing apparatus of the present invention in the fifth embodiment.

### EMBODIMENTS OF THE PRESENT INVENTION

Embodiments of the present invention are illustrated as followed with figures.

### FIRST EMBODIMENT

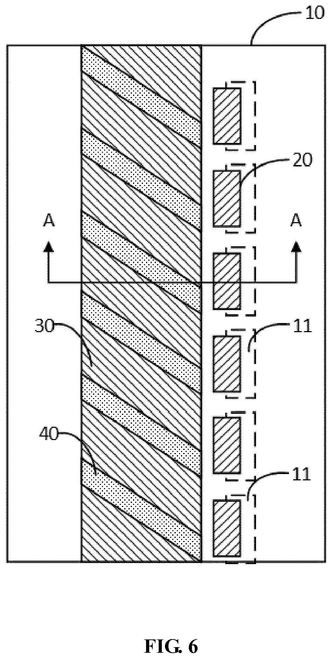

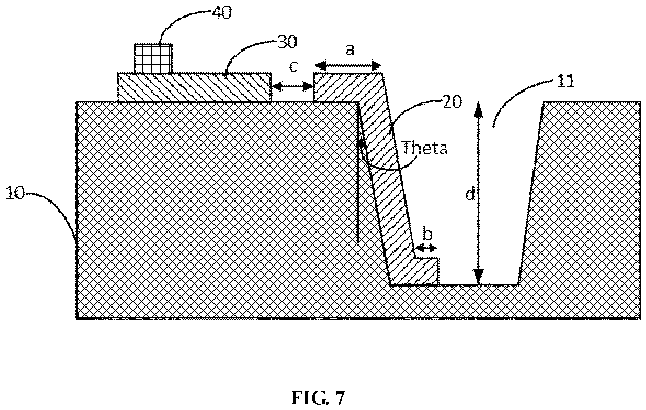

As illustrated in Fig.6 and Fig.7, wherein the Fig.7 is projecting vies of Fig.6 along A-A direction. The present invention discloses a magnetic sensing apparatus, which comprises a Z-axis magnetic sensing component. The Z axis magnetic sensing component comprises: a substrate 10, and at least one pair of coupled magnetic sensing modules; the magnetic sensing modules comprises a magnetic conductive unit 20, and an inducing unit. The substrate 10 may comprise CMOS peripheral circuit. Each pair of magnetic sensing modules may directly offset the output magnetic field signal in X-axis direction or/and Y-axis direction of the pair of magnetic sensing modules, after setup of each pair of magnetic sensing modules in the magnetic sensing apparatus is complete.

There is a dielectric layer on surface of the substrate 10, and grooves 11 in the dielectric layer. One or multiple columns of grooves are set in the substrate. A column of groove comprises multiple sub-grooves 11 in this embodiment.

Main part of the magnetic conductive unit 20 is set in the groove 11, and a part of it is exposed out the groove 11 and to the surface of the substrate, in order to collect magnetic field signal in the Z-axis direction and output the magnetic signal to the inducing unit.

The inducing unit is set on the surface of the substrate, to collect the magnetic field signal in the Z-axis direction output by the magnetic conductive unit 20, and measure corresponding magnetic field strength and direction in the Z-axis direction by the magnetic field signal. The inducing unit comprises magnetic material layer 30, and multiple parallel nodes 40 are set on the magnetic material layer 30. Electrical resistance of the magnetic material in the magnetic material layer 30 relates to direction of the magnetic field. To setup the magnetic conductive unit 20, the inducing unit guide the magnetic field in the Z-axis direction to horizontal direction (X-axis direction or/and Y-axis direction) and then measured.

Meanwhile, the magnetic sensing apparatus also comprises A-axis magnetic sensor, and B-axis magnetic sensor, used for respectively inducing the magnetic signals in X-axis direction and Y-axis direction paralleled to the surface of the substrate (such as strength of the magnetic field and the direction of the magnetic field); The X-axis direction, the Y-axis direction, and the Z-axis direction are perpendicular each other.

The magnetic conductive unit 20 and the magnetic material layer 30 of the inducing unit use same magnetic material, have same number of layers, and are deposited in same process; the magnetic conductive unit 20 and the magnetic material layer 30 of the inducing unit can be AMR, TMR and GMR. Of course, the magnetic conductive unit 20 and the magnetic material layer 30 of the inducing unit may also use different magnetic material, or have different number of layers which are fabricated by multiple times of deposition and lithography.

As illustrated in Fig. 7, angle between the main part of the magnetic conductive unit 20 and the plane that comprising the surface of the substrate is 45°∼90°; and the magnetic material layer 30 of the inducing unit is appressed to the surface of the substrate, and paralleled to the surface of the substrate.

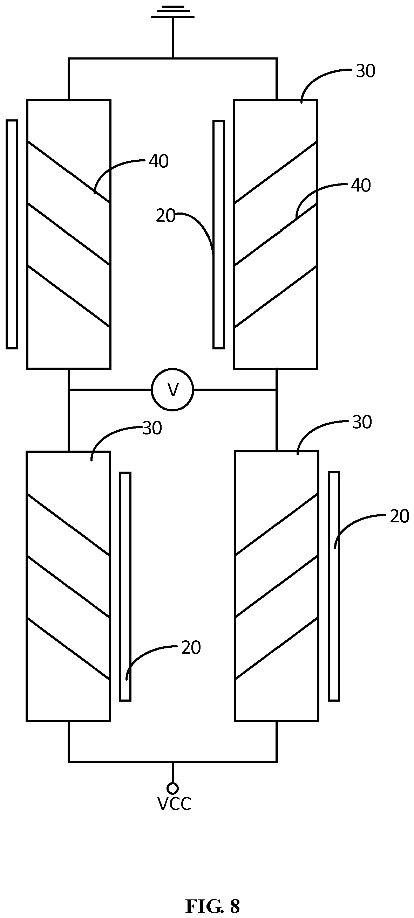

Please refer to Fig. 8, the magnetic conductive unit 20 comprises four magnetic conductive subunits, which are the first magnetic conductive subunit, the second magnetic conductive subunit, the third magnetic conductive subunit, and the fourth magnetic conductive subunit. Refer to Fig. 7, each magnetic conductive subunit comprises multiple magnetic accessories, main part of the magnetic accessory is set in the corresponding groove 11, and a part of it is exposed out of the groove 11; and the exposed part is appressed to the magnetic material layer of the corresponding inducing subunit. Optimized distance c is 0-,20 micrometer, and the typical value is 0 micrometer, 0.5 micrometer, 1.0 micrometer, 1.5 micrometer, 5 micrometer, and 10 micrometer. Meanwhile, as illustrated in Fig. 7, range of a is 0-2 micrometer (such as 0.5 micrometer, and 1 micrometer); range of b is 0-1 micrometer (such as 0 micrometer, 0.1 micrometer, and 0.2 micrometer); range of d is 0.5-10 micrometer (such as 3 micrometer, and 6 micrometer); range of angle Theta is 0-45° (such as 5°).

The inducing unit comprises four inducing subunits, which are the first inducing subunit, the second inducing subunit, the third inducing subunit, and the fourth inducing subunit. Each inducing subunit comprises magnetic material layer 30, electrical resistance of the magnetic material in the magnetic material layer 30 relates to the direction of the magnetic field, electrical resistance of the magnetic material in the magnetic material layer is variable with strength and direction of the magnetic field.

The first magnetic conductive subunit is coupled with the first inducing subunit as the first inducing module of the magnetic sensing component in the Z-axis; the second magnetic conductive subunit is coupled with the second inducing subunit as the second inducing module of the magnetic sensing component in the Z-axis; the third magnetic conductive subunit is coupled with the third inducing subunit as the third inducing module of the magnetic sensing component in the Z-axis; the fourth magnetic conductive subunit is coupled with the fourth inducing subunit as the fourth inducing module of the magnetic sensing component in the Z-axis.

A Wheatstone bridge is used in the magnetic sensing apparatus as illustrated in Fig. 8, to measure the magnetic field more sensitive. In the field of application, the magnetic field can also be measured by only one magnetic conductive subunit and one inducing substrate, which are omitted here.

It need to be point out that, three factors of a pair of magnetic sensing modules need to be set, to offset the output magnetic field signal directly in X-axis direction or/and Y-axis direction of the pair of magnetic sensing modules,
each pair of coupled magnetic sensing modules comprises three factors
(4) the relative locations of the groove and the inducing unit; the groove set in one side of the corresponding inducing unit, or other side; the magnetic conductive unit is at left of the inducing unit, to guide the magnetic field in the third direction to one direction in the surface of the substrate, and the magnetic conductive unit is at right of the inducing unit, to guide the magnetic field in the third direction to other direction in the surface of the substrate;
(5) the inducing unit gets an initial magnetization direction by outer exciting magnetic field; and the initial magnetization directions of the two magnetic sensing modules are set as same or opposite; and
(6) direction of current in the magnetic sensing module; the directions of current in the two magnetic sensing modules are set as same or orthographic.

For each of the coupled two magnetic sensing modules, the first factors in the three factors are set as opposite, and the other two are set as same; or all the factors are set as opposite. Of course, there are many deformation in the present invention, and this embodiment and embodiments below only disclose several typical schemes of them.

Preferably, each pair of the coupled two magnetic sensing modules above is paralleled, that is to say initial magnetization directions of the magnetic material layer in the inducing unit of the two magnetic sensing module are same or opposite, and directions of the grooves in the two magnetic sensing modules are parallel or overlap. The two magnetic sensing modules should be rolled to paralleled before comparing if the two magnetic sensing modules are not paralleled, and then to compare.

Furthermore, each magnetic sensing modules above is paralleled, and the first factors are set as opposite and the other two factors are set as same for the three factors of the two connected magnetic sensing modules; or all the factors are set as opposite.

In one embodiment of the present invention, the apparatus further comprises X-axis Y-axis magnetic sensing component, to induce the magnetic signal in the X-axis or/and Y-axis, and then measure the corresponding magnetic field strength and direction in the X-axis or/and Y-axis direction by it. The X-axis Y-axis magnetic sensing component is not the inducing unit for the Z-axis magnetic sensing component; the inducing unit for the Z-axis magnetic sensing component is for inducing the direction of Z-axis, and the inducing unit for the X-axis Y-axis magnetic sensing component is for inducing the direction of X-axis or/and Y-axis.

The X-axis or Y-axis magnetic sensing component comprises four inducing subunits, which are the fifth inducing subunit, the sixth inducing subunit, the seventh inducing subunit, and the eighth inducing subunit; each of the inducing subunit above comprises a magnetic material layer, on which multiple paralleled electrical nodes are set; and angle between direction of setting the electrical node and direction of magnetization in the magnetic material layer is 10°∼80°, and 45° is optimized. Similarly, the X-axis Y-axis magnetic sensing component may comprise only one inducing unit without Wheatstone bridge.

Structure of the magnetic sensing apparatus in the present invention is introduced above, meanwhile a magnetic induction method is disclosed in the present invention. The method comprises step of inducing the Z-axis magnetic field, and specifically comprise: a magnetic conductive unit collects magnetic signal in the perpendicular direction, and outputs the magnetic signal; an inducing unit receives the magnetic signal in the perpendicular direction output by the magnetic conductive unit, and measure the magnetic field strength and magnetic field direction corresponding to the perpendicular direction by the magnetic signal. Each pair of magnetic sensing modules may directly offset the output magnetic field signal in first or/and second direction of the pair of magnetic sensing modules, after setup of each pair of magnetic sensing modules in the magnetic sensing apparatus is complete.

In addition, the method further comprises the magnetic inducing step in X-axis direction and Y-axis direction, which comprises: induce the magnetic signal in the X-axis direction and Y-axis direction, and measure the magnetic field strength and magnetic field direction corresponding to the X-axis direction and Y-axis direction by the magnetic signal.

Meanwhile, a preparation method for the magnetic sensing apparatus is disclosed in the present invention, which comprise the following steps:
[Step S1] provide a substrate, which can comprises CMOS peripheral circuit;
[Step S2] there is a dielectric layer on surface of the substrate, to isolate the sensing apparatus and the substrate, set grooves in surface of the substrate through fabrication method;
[Step S3] deposit the magnetic material and protection layer, which are single layer or multiple layer respectively, and then form the inducing unit and the magnetic conductive unit at the same process through fabrication method, so the magnetic conductive unit and the inducing unit are formed by same material deposited in same step. The main part of the magnetic conductive unit is deposited in the groove, and a part of it is exposed out the groove to the surface of the substrate.

Preferably, the magnetic sensing apparatus in the present invention also comprises X-axis Y-axis magnetic sensing component; the magnetic material layer needed by the X-axis Y-axis magnetic sensing component is deposited in the same step the inducing unit and the magnetic conductive unit are deposited in the step S3; that is to say the magnetic material layer need by the X-axis, Y-axis and the inducing unit and the magnetic conductive uni- needed by the Z-axis is fabricated in the same step.

Optionally, multiple times of material depositions and fabrication processes are used for forming the inducing unit and the magnetic conductive unit respectively, that is to say different material layers are used for the both.

[Step S4] set the electrical node layer on the inducing unit and the magnetic material layer of the X-axis Y-axis magnetic sensing component, and then finish the fabrication for the whole sensing apparatus through dielectric material depositing, bonding, and so on.

### SECOND EMBODIMENT

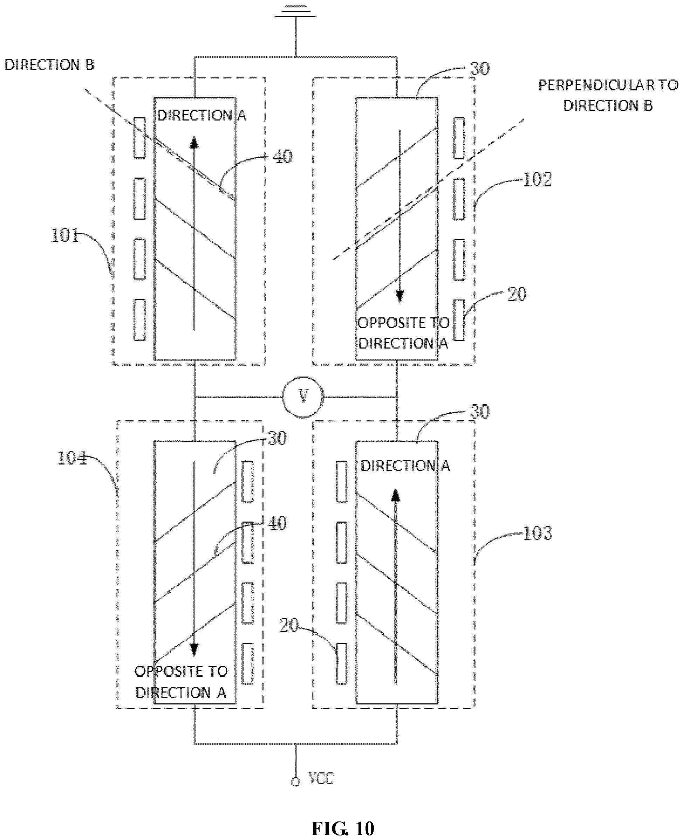

Please refer to Fig. 10, only difference between the present embodiment and the first embodiment is the third direction magnetic sensing component comprises a first magnetic sensing module 101, a second magnetic sensing module 102, a third magnetic sensing module 103, and a fourth magnetic sensing module 104. Each magnetic sensing modules above is paralleled or center points of them are in the same line, that is to say initial magnetization directions of the magnetic material layer in the inducing unit of the two magnetic sensing module are same or opposite, and trends of the grooves in the magnetic sensing modules are paralleled or overlapped.

A first terminal of the first magnetic sensing module 101 and a first terminal of the second magnetic sensing module 102 are grounding, a second terminal of the first magnetic sensing module 101 connects to the a first terminal of the fourth magnetic sensing module 104, a second terminal of the second magnetic sensing module 102 connects to the a first terminal of the third magnetic sensing module 103; a second terminal of the third magnetic sensing module 103 and a second terminal of the fourth magnetic sensing module 104 connect to a power source, and a voltmeter (outputting electrical signal) is connected between a second terminal of the first magnetic sensing module 101 and a second terminal of the second magnetic sensing module 102. The power source, the voltmeter, and the grounding point may be others (such as the grounding point and the power source may be exchanged, and the power source and the voltmeter may be exchanged, and so on), and here are just illustrations.

The grooves coupled to each part of the inducing unit are set in a first side of the coupled part of the inducing unit in the first magnetic sensing module 101; initial magnetization direction of the magnetic material layer in the inducing unit is direction A, and current is direction B;
the grooves coupled to each part of the inducing unit are set in a second side of the coupled part of the inducing unit in the second magnetic sensing module 102; initial magnetization direction of the magnetic material layer in the inducing unit is a direction opposite to the direction A, and current is a direction perpendicular to the direction B;
the grooves coupled to each part of the inducing unit are set in a first side of the coupled part of the inducing unit in the third magnetic sensing module 103; initial magnetization direction of the magnetic material layer in the inducing unit is a direction same to the direction A, and current is a direction paralleled to the direction B;
the grooves coupled to each part of the inducing unit are set in a second side of the coupled part of the inducing unit in the fourth magnetic sensing module 104; initial magnetization direction of the magnetic material layer in the inducing unit is a direction opposite to the direction A, and current is a direction perpendicular to the direction B.

It is disclosed in Fig. 10 that magnetic sensing modules are paralleled each other (such as the first magnetic sensing module 101 and the second magnetic sensing module 102, and the first magnetic sensing module 101 and the fourth magnetic sensing module 104), and for each of the coupled two magnetic sensing modules, the first factor in the three factors is set as opposite, and the other two are set as same; or all the factors are set as opposite.

The magnetic conductive unit and the inducing units comprise a magnetic material layers; material of the magnetic material layer is magneto-resistance material, such as anisotropic magneto-resistance (AMR) material, giant magneto-resistance (GMR) material, or tunneling magneto-resistance (TMR) material; character of them is that electrical resistivity of the material is variable depending on variation of magnetic field.

### THIRD EMBODIMENT

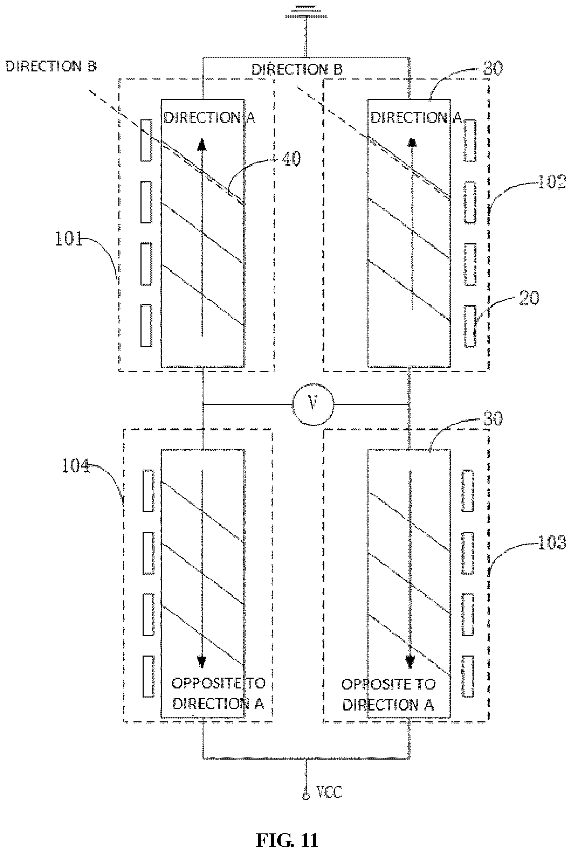

Please refer to Fig. 11, only difference between the present embodiment and the first embodiment is the third direction magnetic sensing component comprises a first magnetic sensing module 101, a second magnetic sensing module 102, a third magnetic sensing module 103, and a fourth magnetic sensing module 104. Each magnetic sensing modules above is paralleled or center points of them are in the same line, that is to say initial magnetization direction of the magnetic material layer in the inducing unit of the two magnetic sensing module is same or opposite, and trend of the grooves in the magnetic sensing modules are paralleled or overlapped.

A first terminal of the first magnetic sensing module 101 and a first terminal of the second magnetic sensing module 102 are grounding, a second terminal of the first magnetic sensing module 101 connects to the a first terminal of the fourth magnetic sensing module 104, a second terminal of the second magnetic sensing module 102 connects to the a first terminal of the third magnetic sensing module 103; a second terminal of the third magnetic sensing module 103 and a second terminal of the fourth magnetic sensing module 104 connect to a power source, and an electrical signal outputs between a second terminal of the first magnetic sensing module 101 and a second terminal of the second magnetic sensing module 102.

The grooves coupled to each part of the inducing unit are set in a first side of the coupled part of the inducing unit in the first magnetic sensing module 101; initial magnetization direction of the magnetic material layer in the inducing unit is direction A, and current is direction B;
the grooves coupled to each part of the inducing unit are set in a second side of the coupled part of the inducing unit in the second magnetic sensing module 102; initial magnetization direction of the magnetic material layer in the inducing unit is a direction same to the direction A, and current is a direction paralleled to the direction B;
the grooves coupled to each part of the inducing unit are set in a second side of the coupled part of the inducing unit in the third magnetic sensing module 103; initial magnetization direction of the magnetic material layer in the inducing unit is a direction opposite to the direction A, and current is a direction paralleled to the direction B;
the grooves coupled to each part of the inducing unit are set in a first side of the coupled part of the inducing unit in the fourth magnetic sensing module 104; initial magnetization direction of the magnetic material layer in the inducing unit is a direction opposite to the direction A, and current is a direction paralleled to the direction B.

Principle of the magnetic sensing apparatus is anisotropic magneto-resistance (AMR), giant magneto-resistance (GMR), or tunneling magneto-resistance (TMR).

### FOURTH EMBODIMENT

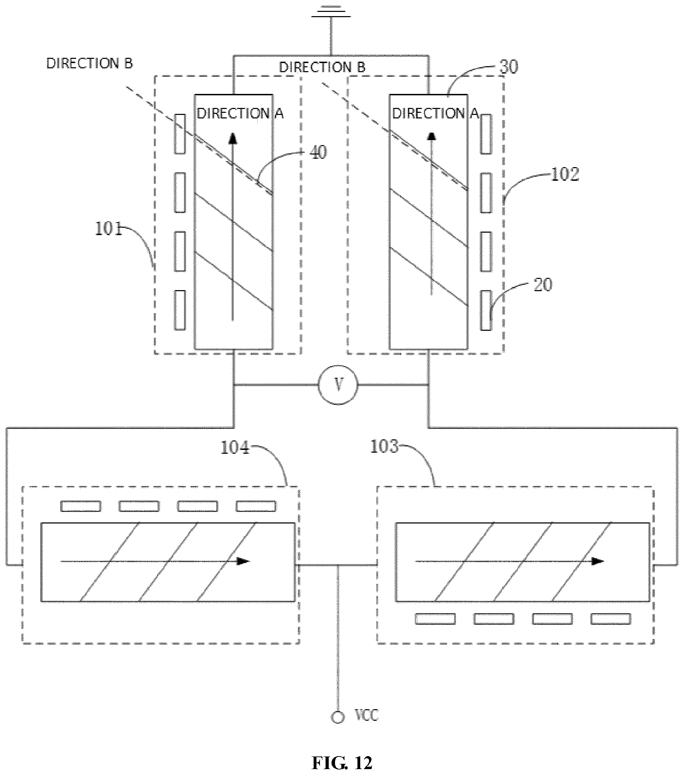

Please refer to Fig. 12, only difference between the present embodiment and the first embodiment is the third direction magnetic sensing component comprises a first magnetic sensing module 101, a second magnetic sensing module 102, a third magnetic sensing module 103, and a fourth magnetic sensing module 104.

Center points of the first magnetic sensing module 101 and the second magnetic sensing module 102 are in the same line, that is to say magnetization directions of the magnetic material layer in the inducing unit of the first magnetic sensing module 101 and the second magnetic sensing module 102 are same or opposite, and trends of the grooves in the magnetic sensing modules are paralleled or overlapped.

The third magnetic sensing module 103 and the fourth magnetic sensing module 104 are respectively perpendicular to the first magnetic sensing module 101, that is to say initial magnetization directions of the magnetic material layer in the inducing unit of the third magnetic sensing module 103 and the fourth magnetic sensing module 104 are respectively perpendicular to the first magnetic sensing module 101, and trend of the grooves in the third magnetic sensing module 103 and the fourth magnetic sensing module 104 are respectively perpendicular to trend of the corresponding grooves in the first magnetic sensing module 101.

A first terminal of the first magnetic sensing module 101 and a first terminal of the second magnetic sensing module 102 are grounding, a second terminal of the first magnetic sensing module 101 connects to the a first terminal of the fourth magnetic sensing module 104, a second terminal of the second magnetic sensing module 102 connects to the a first terminal of the third magnetic sensing module 103; a second terminal of the third magnetic sensing module 103 and a second terminal of the fourth magnetic sensing module 104 connect to a power source, and an electrical signal outputs between a second terminal of the first magnetic sensing module 101 and a second terminal of the second magnetic sensing module 102.

For the coupled first magnetic sensing module 101 and the second magnetic sensing module 102, the relative locations of the groove and the inducing units for them are set as opposite, and the initial magnetization directions and the current directions are set as same in the three factors.

For the coupled third magnetic sensing module 103 and the fourth magnetic sensing module 104, the relative locations of the groove and the inducing units for them are set as opposite, and the initial magnetization directions and current directions are set as same in the three factors.

### FIFTH EMBODIMENT

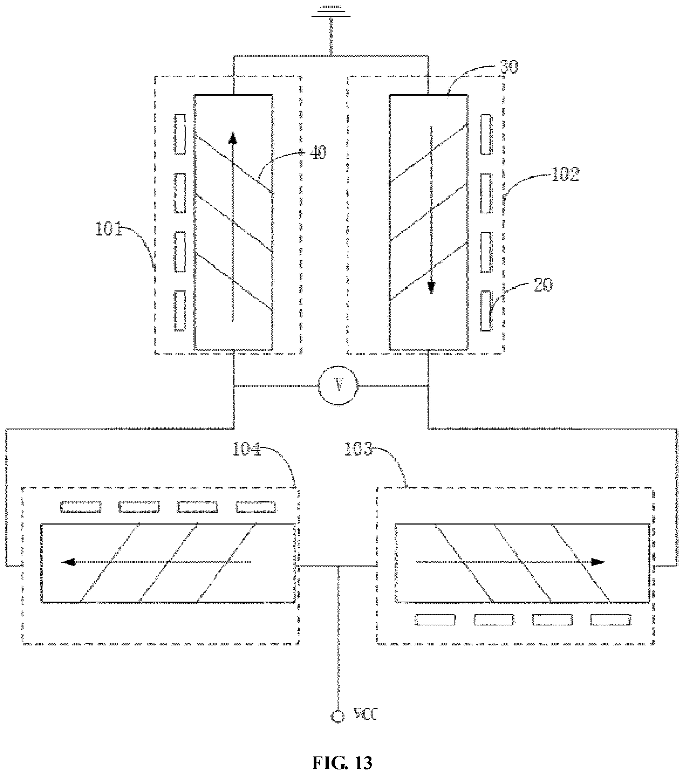

Please refer to Fig. 13, difference between the present embodiment and the fourth embodiment is that, all the three factors for the coupled first magnetic sensing module 101 and the second magnetic sensing module 102 are set as opposite.

All the three factors for the coupled third magnetic sensing module 103 and the second magnetic sensing module 102 are set as opposite.

### SIXTH EMBODIMENT

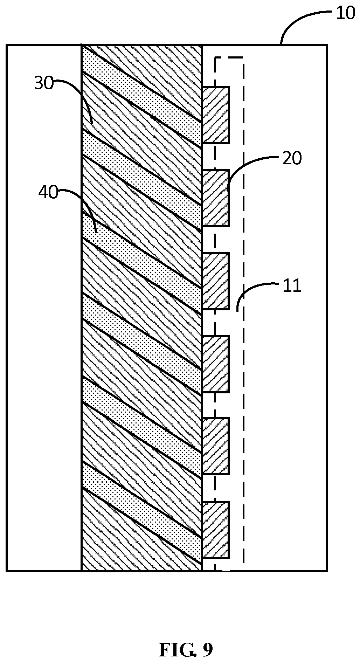

Difference between the present embodiment and the first embodiment is a groove is shared by multiple of magnetic conductive structures in the present embodiment; please refer to Fig.9, the grooves 11 on the substrate 10 may be set as one column or multiple of columns, and a column of grooves 11 may be set as a narrow groove, used for multiple of magnetic component. Otherwise, the magnetic conductive unit is connected to the sensing unit in this structure, that is to say the distance is 0 micrometer.

### SEVENTH EMBODIMENT

In, the present embodiment, the magnetic sensing apparatus in the present invention also comprises CMOS chip, and the substrate mentioned in the first embodiment is set on the CMOS chip. It is to say the magnetic sensing apparatus have functions of the CMOS chip in prior art, That is to say functions of the CMOS chip and the sensing apparatus are integrated into a single chip that have high integration.

### EIGHTH EMBODIMENT

In the present embodiment, the magnetic material layer needed by the magnetic conductive unit of the magnetic sensing apparatus, inducing unit, and X axis Y axis magnetic sensing component comprises magnetic sensitive material, such as NiFe alloy, and may also comprise buffer layer, such as TaN, and so on. Wherein, the magnetic sensitive material layer and the buffer layer can be multiple layers material.

The magnetic sensitive material comprises anisotropic magneto-resistance material, giant magneto-resistance material, or tunneling magneto-resistance material; it can be multiple layer or single layer; and thickness and number of layers of the multiple layer material can be adjusted by needed.

In addition, multiple magnetic conductive structure can be coupled to one group of magnetic conductive unit, to make the measurement more sensitive.

### NINTH EMBODIMENT

In the present embodiment, three dimensions that the magnetic sensing apparatus can induce are not the first direction, the second direction, and the perpendicular direction of X-axis, Y-axis and Z-axis, and the first direction, the second direction, and the perpendicular direction which are perpendicular for any two should meet the requirements.

In conclusion, the magnetic sensing apparatus and magnetic induction method thereof are provided in the present invention, which can set the sensing devices for X-axis, Y-axis, and Z-axis in one wafer or chip, to have good manufacturability, good performance and obvious competitive price. Each pair of magnetic sensing modules can independently measure the magnetic field signal in X-axis direction, Y-axis direction, and Z-axis direction in the present invention, after setup of each pair of coupled magnetic sensing modules is complete.

The description and application of the present invention are illustrative, and does not tend to restrict the present invention to the embodiments above. Any transformation and change are allowed for the embodiments, and to replace any embodiment and any components is well known for common skilled persons in the technical field. The skilled persons in the technical field should be clear that, the present invention can be in other forms, structure, layout, scale, and other devices, materials and components, within the essential characteristics of the present invention. Any transformation and change are allowed for the embodiments disclosed here, within the scope of the present invention.

## Claims

1. A magnetic sensing apparatus, wherein the apparatus comprises a third direction magnetic sensing component, the third direction magnetic sensing component comprises a substrate and a pair of coupled magnetic sensing modules, a groove (11) is set in a surface of the substrate; and each magnetic sensing module comprises:
a magnetic conductive unit, wherein a main part of the magnetic conductive unit (20) is set in the groove, and a part of it is exposed outside the groove and on the surface of the substrate, arranged to collect a magnetic field signal in the third direction and to output the magnetic field signal; and
an inducing unit (30, 40) set on the surface of the substrate, arranged to receive the magnetic field signal in the third direction and to measure the corresponding magnetic field strength in the third direction of the magnetic field signal; wherein the inducing unit comprises a magnetic material layer, an electrical resistance of the magnetic material in the magnetic material layer being variable with the magnetic field strength and direction; **characterised in that** the sensing apparatus is arranged such that output magnetic signals in a first direction or/and a second direction for every pair of coupled magnetic sensing modules can be offset, after the corresponding pair of coupled magnetic sensing modules is settled;
wherein the third direction magnetic sensing component comprises a first magnetic sensing module, a second magnetic sensing module, a third magnetic sensing module, and a fourth magnetic sensing module, forming pairs of coupled magnetic sensing modules;
the two magnetic sensing modules of each pair being paralleled, such that initial magnetization directions of the magnetic material layer in the inducing units of the two magnetic sensing modules are the same or
opposite, and trends of the grooves in the two magnetic sensing modules are paralleled or overlapped;
wherein a first terminal of the first magnetic sensing module and a first terminal of the second magnetic sensing module are connected to ground, a second
terminal of the first magnetic sensing module connects to the a first terminal of the fourth magnetic sensing module, a second terminal of the second magnetic sensing module connects to the first terminal of the third magnetic sensing module; a second terminal of the third magnetic sensing module and a second terminal of the fourth magnetic sensing module connect to a power source, and the sensing apparatus is configured such that an electrical signal is output between the second terminal of the first magnetic sensing module and the second terminal of the second magnetic sensing module;
wherein the grooves coupled to each part of the inducing unit are set in a first side of the coupled part of the inducing unit in the first magnetic sensing module; initial magnetization direction of the magnetic material layer in the inducing unit is direction A, and current is direction B;
wherein the grooves coupled to each part of the inducing unit are set in a second side of the coupled part of the inducing unit in the second magnetic sensing module; initial magnetization direction of the magnetic material layer in the inducing unit is a direction opposite to the direction A, and
current is a direction perpendicular to the direction B;
wherein the grooves coupled to each part of the inducing unit are set in a first side of the coupled part of the inducing unit in the third magnetic sensing module; the sensing apparatus is configured such that initial magnetization direction of the magnetic material layer in the inducing unit is in a direction parallel to the direction A, and current
is in a direction paralleled to the direction B;
wherein the grooves coupled to each part of the inducing unit are set in a second side of the coupled part of the inducing unit in the fourth magnetic sensing module; the sensing apparatus is configured such that the initial magnetization direction of the magnetic material layer in the inducing unit is in a direction opposite to the direction A, and
current is in a direction perpendicular to the direction B;
wherein each magnetic conductive unit comprises four magnetic conductive subunits, which are a first magnetic conductive subunit, a second magnetic conductive subunit, a third magnetic conductive subunit, and a fourth magnetic conductive subunit;
wherein each inducing unit comprises four inducing subunits, which are a first inducing subunit, a second inducing subunit, a third inducing subunit, and a fourth inducing subunit;
wherein the first magnetic conductive subunit is coupled with the first inducing subunit as the first inducing module of the magnetic sensing component in the third direction;
wherein the second magnetic conductive subunit is coupled with the second inducing subunit as the second inducing module of the magnetic sensing component in the third direction;
wherein the third magnetic conductive subunit is coupled with the third inducing subunit as the third inducing module of the magnetic sensing component in the third direction;
wherein the fourth magnetic conductive subunit is coupled with the fourth inducing subunit as the fourth inducing module of the magnetic sensing component in the third direction;
wherein each inducing subunit comprises a magnetic material layer, an electrical resistance of magnetic material in the magnetic material layer being variable depending on the magnetic field strength and direction;
wherein one or multiple columns of grooves are set in the substrate, and a column of grooves is formed by a long groove, or a column of grooves comprises multiple sub-grooves;
wherein each magnetic conductive subunit comprises multiple magnetic accessories, a main part of the magnetic accessory being set in the corresponding groove, and a part of it being exposed out of the groove; and
the exposed part being appressed to the magnetic material layer of the corresponding inducing subunit;
wherein each magnetic accessory has the exposed part out of the groove, and
distance between the exposed part and the magnetic material layer of the corresponding inducing subunit is 0-20 micrometer; and
wherein each magnetic conductive unit and the magnetic material layer of each inducing unit have been formed by the same magnetic material, and
have the same number of layers which have been deposited in the same step;
or each magnetic conductive unit and the magnetic material layer of each inducing unit have been formed by different magnetic materials deposited in different steps.

2. The magnetic sensing apparatus according to claim 1, wherein:
the third direction magnetic sensing component is a perpendicular direction magnetic sensing component;
the magnetic conductive unit is used for collecting the magnetic field signal in the perpendicular direction and outputting the magnetic signal;
the inducing unit is a magnetic sensor inducing magnetic field paralleled to the surface of the substrate, sets on the surface of the substrate, used for receiving the magnetic field signal in the perpendicular direction output by the magnetic conductive unit, and measuring corresponding magnetic field strength in the perpendicular direction by the magnetic field signal; and
the magnetic sensing apparatus further comprises a first magnetic sensor, and a second magnetic sensor, arranged to induce magnetic fields in the first
direction, and the second direction respectively; and the first direction and the second direction are perpendicular.

3. The magnetic sensing apparatus according to claim 1, wherein:
the magnetic sensing apparatus further comprises a first magnetic sensor, and a second magnetic sensor, arranged to induce magnetic field in the first direction, and the second direction respectively; and the first direction, the second direction and the third direction are perpendicular each other.

4. The magnetic sensing apparatus according to claim 1, wherein:
each pair of coupled magnetic sensing modules comprises three factors
(1) the relative locations of the groove and the inducing unit; the groove sets in one side of the corresponding inducing unit, or other side; the magnetic conductive unit is at left of the inducing unit, to guide the magnetic field in the third direction to one direction in the surface of the substrate, and the magnetic conductive unit is at right of the inducing unit, to guide the magnetic field in the third direction to other direction in the surface of the substrate;
(2) the inducing unit gets an initial magnetization direction by outer exciting magnetic field; and the initial magnetization directions of the two magnetic sensing modules are set as same or opposite; and
(3) direction of current in the magnetic sensing module; the directions of current in the two magnetic sensing modules are set as same or orthographic;
for each of the coupled two magnetic sensing modules, the first factors in the three factors are set as opposite, and the other two are set as same; or all the factors are set as opposite;
comparison of the two magnetic sensing modules above is based on the two magnetic sensing modules are paralleled.

5. The magnetic sensing apparatus according to claim 4, wherein:
each magnetic sensing modules is paralleled, and the first factors are set as opposite and the other two factors are set as same for the three factors of the two connected magnetic sensing modules; or all the factors are set as opposite.

6. The magnetic sensing apparatus according to anyone of claims 1 to 5, wherein:
the third direction magnetic sensing component comprises a first magnetic sensing module, a second magnetic sensing module, a third magnetic sensing module, and a fourth magnetic sensing module;
each magnetic sensing modules above is paralleled, that is to say initial magnetization directions of the magnetic material layer in the inducing unit of the two magnetic sensing module are same or opposite, and trend of the grooves in the magnetic sensing modules are paralleled or overlapped;
a first terminal of the first magnetic sensing module and a first terminal of the second magnetic sensing module are grounding, a second terminal of the first magnetic sensing module connects to the a first terminal of the fourth magnetic sensing module, a second terminal of the second magnetic sensing module connects to the a first terminal of the third magnetic sensing module;
a second terminal of the third magnetic sensing module and a second terminal of the fourth magnetic sensing module connect to a power source,
and an electrical signal is output between a second terminal of the first magnetic sensing module and a second terminal of the second magnetic sensing module;
the grooves coupled to each part of the inducing unit are set in a first side of the coupled part of the inducing unit in the first magnetic sensing module;
initial magnetization direction of the magnetic material layer in the inducing unit is direction A, and current is direction B;
the grooves coupled to each part of the inducing unit are set in a second side of the coupled part of the inducing unit in the second magnetic sensing module; initial magnetization direction of the magnetic material layer in the inducing unit is a direction same to the direction A, and current is a direction paralleled to the direction B;
the grooves coupled to each part of the inducing unit are set in a first side of the coupled part of the inducing unit in the third magnetic sensing module;
initial magnetization direction of the magnetic material layer in the inducing unit is a direction same to the direction A, and current is a direction paralleled to the direction B;
the grooves coupled to each part of the inducing unit are set in a second side of the coupled part of the inducing unit in the fourth magnetic sensing module; initial magnetization direction of the magnetic material layer in the inducing unit is a direction same to the direction A, and current is a direction paralleled to the direction B.

7. The magnetic sensing apparatus according to claim 4 or 5, wherein:
the third direction magnetic sensing component comprises a first magnetic sensing module, a second magnetic sensing module, a third magnetic sensing module, and a fourth magnetic sensing module;
center points of the first magnetic sensing module and the second magnetic sensing module are in the same line, that is to say magnetization directions of the magnetic material layer in the inducing unit of the first magnetic sensing module and the second magnetic sensing module are same or
opposite, and trend of the grooves in the magnetic sensing modules are paralleled or overlapped;
the third magnetic sensing module and the fourth magnetic sensing module are respectively perpendicular to the first magnetic sensing module and the second magnetic sensing module, that is to say initial magnetization directions of the magnetic material layer in the inducing unit of the third magnetic sensing module and the fourth magnetic sensing module are respectively perpendicular to the first magnetic sensing module and the second magnetic sensing module, and trend of the grooves in the third magnetic sensing module and the fourth magnetic sensing module are respectively perpendicular to trend of the corresponding grooves in the first magnetic sensing module and the second magnetic sensing module;
a first terminal of the first magnetic sensing module and a first terminal of the second magnetic sensing module are grounding, a second terminal of the first magnetic sensing module connects to the a first terminal of the fourth magnetic sensing module, a second terminal of the second magnetic sensing module connects to the a first terminal of the third magnetic sensing module;
a second terminal of the third magnetic sensing module and a second terminal of the fourth magnetic sensing module connect to a power source,
and an electrical signal is output between a second terminal of the first magnetic sensing module and a second terminal of the second magnetic sensing module;
for the coupled first magnetic sensing module and the second magnetic sensing module, the relative location of the groove and the inducing units for them are set as opposite, and the initial magnetization directions and the current directions are set as same in the three factors; or the relative location of the groove and the inducing units for them are set as opposite, the initial magnetization directions set as opposite, and the current directions are perpendicular;
for the coupled third magnetic sensing module and the fourth magnetic sensing module, the relative location of the groove and the inducing units for them are set as opposite, and the initial magnetization directions and current directions are set as same in the three factors; or the relative location of the groove and the inducing units for them are set as opposite, the initial magnetization directions set as opposite, and the current directions are perpendicular.

8. The magnetic sensing apparatus according to claim 1, wherein:
the third direction magnetic sensing component comprises a peripheral circuit, used for calculating magnetic field strength and magnetic field direction, and outputting;
angle between main part of the magnetic conductive unit and surface of the substrate is 45°∼90°; the inducing unit is appressed to the surface of the substrate, and paralleled to the surface of the substrate;
the first direction is X-axis, the second direction is Y-axis, and the third direction is Z-axis.

9. The magnetic sensing apparatus according to claim 1, wherein:
the apparatus further comprises a second magnetic sensing component, used for sensing magnetic signal in the first direction or/and the second direction, and measuring the corresponding magnetic field strength and magnetic field direction in the first direction or/and the second direction by it.

10. The magnetic sensing apparatus according to claim 9, wherein:
the second magnetic sensing component comprises four inducing subunits, which are a fifth inducing subunit, a sixth inducing subunit, a seventh inducing subunit, and an eighth inducing subunit;
each inducing subunit above comprises a magnetic material layer, electrical resistance of magnetic material in the magnetic material layer is variable depending on the magnetic field strength and direction.

11. The magnetic sensing apparatus according to anyone of claims 1 to 5, wherein:
the magnetic conductive unit and the inducing unit comprise magnetic material layers respectively; and
the material of the magnetic material layer is magneto-resistance material, anisotropic magneto-resistance (AMR) material, giant magneto-resistance (GMR) material, or tunneling magneto-resistance (TMR) material; wherein the character of them is AMR, GMR, or TMR.

12. A magnetic induction method using the magnetic sensing apparatus described in anyone of claims 1 to 11, wherein the method comprises steps of inducing magnetic field in the third direction, and specifically comprises:
a magnetic conductive unit collects magnetic signal in the third direction, and outputs the magnetic signal;
an inducing unit receives the magnetic signal in the third direction output by the magnetic conductive unit, and measure the magnetic field strength and magnetic field direction corresponding to the third direction by the magnetic signal; and
each pair of magnetic sensing modules can directly offset the output magnetic field signal in first or/and second direction of the pair of magnetic sensing modules, after setup of each pair of magnetic sensing modules in the magnetic sensing apparatus is complete.

13. The magnetic induction method according to claim 12, wherein:
the method further comprises the inducing step in first direction and second direction, and induce the magnetic signal in the first direction and second direction, and measure the magnetic field strength and magnetic field direction corresponding to the first direction and the second direction by them.

## Patentansprüche

1. Magnetsensorvorrichtung, wobei die Vorrichtung eine Drittrichtungs-Magnetsensorkomponente umfasst, die Drittrichtungs-Magnetsensorkomponente ein Substrat und ein Paar gekoppelter Magnetsensormodule umfasst, eine Nut (11) in einer Oberfläche des Substrats angeordnet ist; und
jedes Magnetsensormodul umfasst:
eine magnetische leitfähige Einheit, wobei ein Hauptteil der magnetischen leitfähigen Einheit (20) in der Nut angeordnet ist und ein Teil davon außerhalb der Nut und auf der Oberfläche des Substrats freiliegt, die dazu angeordnet ist, ein Magnetfeldsignal in der dritten Richtung zu erfassen und das Magnetfeldsignal auszugeben; und
eine Induktionseinheit (30, 40), die auf der Oberfläche des Substrats angeordnet ist und dazu angeordnet ist, das Magnetfeldsignal in der dritten Richtung zu empfangen und die entsprechende Magnetfeldstärke in der dritten Richtung des Magnetfeldsignals zu messen;
wobei die Induktionseinheit eine Magnetmaterialschicht umfasst, wobei ein elektrischer Widerstand des magnetischen Materials in der Magnetmaterialschicht je nach der Magnetfeldstärke und -richtung veränderlich ist;
**dadurch gekennzeichnet, dass**
die Sensorvorrichtung derart angeordnet ist, dass ausgegebene magnetische Signale in einer ersten Richtung oder/und einer zweiten Richtung für jedes Paar gekoppelter Magnetsensormodule versetzt werden können, nachdem das entsprechende Paar gekoppelter Magnetsensormodule installiert ist;
wobei die Drittrichtungs-Magnetsensorkomponente ein erstes Magnetsensormodul, ein zweites Magnetsensormodul, ein drittes Magnetsensormodul und ein viertes Magnetsensormodul umfasst, die Paare gekoppelter Magnetsensormodule ausbilden;
wobei die zwei Magnetsensormodule jedes Paars parallelisiert sind, derart dass anfängliche Magnetisierungsrichtungen der Magnetmaterialschicht in den Induktionseinheiten der zwei Magnetsensormodule gleich oder entgegengesetzt sind und Verläufe der Nuten in den zwei Magnetsensormodulen parallelisiert oder überlappt sind;
wobei ein erster Anschluss des ersten Magnetsensormoduls und ein erster Anschluss des zweiten Magnetsensormoduls geerdet sind, ein zweiter Anschluss des ersten Magnetsensormoduls mit dem einem ersten Anschluss des vierten Magnetsensormoduls verbunden ist, ein zweiter Anschluss des zweiten Magnetsensormoduls mit dem ersten Anschluss des dritten Magnetsensormoduls verbunden ist; ein zweiter Anschluss des dritten Magnetsensormoduls und ein zweiter Anschluss des vierten Magnetsensormoduls mit einer Energiequelle verbunden sind und die Sensorvorrichtung derart ausgestaltet ist, dass ein elektrisches Signal zwischen dem zweiten Anschluss des ersten Magnetsensormoduls und dem zweiten Anschluss des zweiten Magnetsensormoduls ausgegeben wird;
wobei die Nuten, die mit jedem Teil der Induktionseinheit gekoppelt sind, in einer ersten Seite des gekoppelten Teils der Induktionseinheit in dem ersten Magnetsensormodul angeordnet sind; eine anfängliche Magnetisierungsrichtung der Magnetmaterialschicht in der Induktionseinheit eine Richtung A ist und ein Strom eine Richtung B ist; wobei die Nuten, die mit jedem Teil der Induktionseinheit gekoppelt sind, in einer zweiten Seite des gekoppelten Teils der Induktionseinheit in dem zweiten Magnetsensormodul angeordnet sind; eine anfängliche Magnetisierungsrichtung der Magnetmaterialschicht in der Induktionseinheit eine Richtung entgegengesetzt zur Richtung A ist und ein Strom eine Richtung senkrecht zur Richtung B ist;
wobei die Nuten, die mit jedem Teil der Induktionseinheit gekoppelt sind, in einer ersten Seite des gekoppelten Teils der Induktionseinheit in dem dritten Magnetsensormodul angeordnet sind; die Sensorvorrichtung derart ausgestaltet ist, dass eine anfängliche Magnetisierungsrichtung der Magnetmaterialschicht in der Induktionseinheit in einer Richtung parallel zur Richtung A verläuft und ein Strom in einer Richtung parallelisiert zur Richtung B vorliegt;
wobei die Nuten, die mit jedem Teil der Induktionseinheit gekoppelt sind, in einer zweiten Seite des gekoppelten Teils der Induktionseinheit in dem vierten Magnetsensormodul angeordnet sind; die Sensorvorrichtung derart ausgestaltet ist, dass die anfängliche Magnetisierungsrichtung der Magnetmaterialschicht in der Induktionseinheit in einer Richtung entgegengesetzt zur Richtung A verläuft und ein Strom in einer Richtung senkrecht zur Richtung B vorliegt;
wobei jede magnetische leitfähige Einheit vier magnetische leitfähige Untereinheiten umfasst, die eine erste magnetische leitfähige Untereinheit, eine zweite magnetische leitfähige Untereinheit, eine dritte magnetische leitfähige Untereinheit und eine vierte magnetische leitfähige Untereinheit sind;
wobei jede Induktionseinheit vier Induktionsuntereinheiten umfasst, die eine erste Induktionsuntereinheit, eine zweite Induktionsuntereinheit,
eine dritte Induktionsuntereinheit und eine vierte Induktionsuntereinheit sind;
wobei die erste magnetische leitfähige Untereinheit mit der ersten Induktionsuntereinheit als das erste Induktionsmodul der Magnetsensorkomponente in der dritten Richtung gekoppelt ist;
wobei die zweite magnetische leitfähige Untereinheit mit der zweiten Induktionsuntereinheit als das zweite Induktionsmodul der Magnetsensorkomponente in der dritten Richtung gekoppelt ist;
wobei die dritte magnetische leitfähige Untereinheit mit der dritten Induktionsuntereinheit als das dritte Induktionsmodul der Magnetsensorkomponente in der dritten Richtung gekoppelt ist;
wobei die vierte magnetische leitfähige Untereinheit mit der vierten Induktionsuntereinheit als das vierte Induktionsmodul der Magnetsensorkomponente in der dritten Richtung gekoppelt ist;
wobei jede Induktionsuntereinheit eine Magnetmaterialschicht umfasst,
wobei ein elektrischer Widerstand von magnetischem Material in der Magnetmaterialschicht in Abhängigkeit von der Magnetfeldstärke und -richtung veränderlich ist;
wobei eine oder mehrere Kolonnen von Nuten in dem Substrat angeordnet sind und eine Kolonne von Nuten durch eine lange Nut ausgebildet wird oder eine Kolonne von Nuten mehrere Teilnuten umfasst;
wobei jede magnetische leitfähige Untereinheit mehrere magnetische Zubehörteile umfasst, wobei ein Hauptteil des magnetischen Zubehörteils in der entsprechenden Nut angeordnet ist und ein Teil davon außerhalb der Nut freiliegt; und der freiliegende Teil an die Magnetmaterialschicht der entsprechenden Induktionsuntereinheit gedrückt wird;
wobei jedes magnetische Zubehörteil den freiliegenden Teil außerhalb der Nut aufweist und ein Abstand zwischen dem freiliegenden Teil und der Magnetmaterialschicht der entsprechenden Induktionsuntereinheit 0-20 Mikrometer beträgt; und
wobei jede magnetische leitfähige Einheit und die Magnetmaterialschicht jeder Induktionseinheit aus dem gleichen magnetischen Material ausgebildet wurden und die gleiche Anzahl von Schichten aufweisen, die in dem gleichen Schritt abgeschieden wurden; oder jede magnetische leitfähige Einheit und die Magnetmaterialschicht jeder Induktionseinheit aus verschiedenen magnetischen Materialien ausgebildet wurden, die in verschiedenen Schritten abgeschieden wurden.

2. Magnetsensorvorrichtung nach Anspruch 1, wobei:
die Drittrichtungs-Magnetsensorkomponente eine Senkrechtrichtungs-Magnetsensorkomponente ist;
die magnetische leitfähige Einheit zum Erfassen des Magnetfeldsignals in der senkrechten Richtung und Ausgeben des magnetischen Signals benutzt wird;
die Induktionseinheit ein Magnetsensor ist, der ein Magnetfeld induziert, das zur Oberfläche des Substrats parallelisiert ist, auf der Oberfläche des Substrats sitzt, zum Empfangen des Magnetfeldsignals in der senkrechten Richtung, das durch die magnetische leitfähige Einheit ausgegeben wird, und Messen einer entsprechenden Magnetfeldstärke in der senkrechten Richtung anhand des Magnetfeldsignals benutzt wird; und
die Magnetsensorvorrichtung ferner einen ersten Magnetsensor und
einen zweiten Magnetsensor umfasst, die dazu angeordnet sind, entsprechend Magnetfelder in der ersten Richtung und der zweiten Richtung zu induzieren; und die erste Richtung und die zweite Richtung senkrecht sind.

3. Magnetsensorvorrichtung nach Anspruch 1, wobei:
die Magnetsensorvorrichtung ferner einen ersten Magnetsensor und einen zweiten Magnetsensor umfasst, die dazu angeordnet sind,
entsprechend ein Magnetfeld in der ersten Richtung und der zweiten Richtung zu induzieren; und die erste Richtung, die zweite Richtung und die dritte Richtung senkrecht zueinander sind.

4. Magnetsensorvorrichtung nach Anspruch 1, wobei:
jedes Paar gekoppelter Magnetsensormodule drei Faktoren umfasst:
(1) die relativen Positionen der Nut und der Induktionseinheit; die Nut sitzt in einer Seite der entsprechenden Induktionseinheit oder der anderen Seite; die magnetische leitfähige Einheit befindet sich links der Induktionseinheit, um das Magnetfeld in der dritten Richtung zu einer Richtung in der Oberfläche des Substrats zu leiten, und die magnetische leitfähige Einheit befindet sich rechts der Induktionseinheit, um das Magnetfeld in der dritten Richtung zu einer anderen Richtung in der Oberfläche des Substrats zu leiten;
(2) die Induktionseinheit erhält durch ein äußeres anregendes Magnetfeld eine anfängliche Magnetisierungsrichtung; und die anfänglichen Magnetisierungsrichtungen der zwei Magnetsensormodule sind als gleich oder entgegengesetzt eingestellt; und
(3) eine Stromrichtung in dem Magnetsensormodul; die Stromrichtungen in den zwei Magnetsensormodulen sind als gleich oder orthographisch eingestellt;
bezüglich jedes der gekoppelten zwei Magnetsensormodule die ersten Faktoren im Rahmen der drei Faktoren als entgegengesetzt eingestellt sind und die anderen zwei als gleich eingestellt sind; oder alle Faktoren als entgegengesetzt eingestellt sind;
ein Vergleich der zwei obigen Magnetsensormodule darauf basiert, dass die zwei Magnetsensormodule parallelisiert sind.

5. Magnetsensorvorrichtung nach Anspruch 4, wobei:
jedes Magnetsensormodul parallelisiert ist und bezüglich der drei Faktoren der zwei verbundenen Magnetsensormodule die ersten Faktoren als entgegengesetzt eingestellt sind und die anderen zwei Faktoren als gleich eingestellt sind; oder alle Faktoren als entgegengesetzt eingestellt sind.

6. Magnetsensorvorrichtung nach einem der Ansprüche 1 bis 5, wobei:
die Drittrichtungs-Magnetsensorkomponente ein erstes Magnetsensormodul, ein zweites Magnetsensormodul, ein drittes Magnetsensormodul und ein viertes Magnetsensormodul umfasst;
jedes obige Magnetsensormodul parallelisiert ist, das heißt anfängliche Magnetisierungsrichtungen der Magnetmaterialschicht in der Induktionseinheit der zwei Magnetsensormodule gleich oder entgegengesetzt sind und ein Verlauf der Nuten in den Magnetsensormodulen parallelisiert oder überlappt sind;
ein erster Anschluss des ersten Magnetsensormoduls und ein erster Anschluss des zweiten Magnetsensormoduls erdend sind, ein zweiter Anschluss des ersten Magnetsensormoduls mit dem einem ersten Anschluss des vierten Magnetsensormoduls verbunden ist, ein zweiter Anschluss des zweiten Magnetsensormoduls mit dem einem ersten Anschluss des dritten Magnetsensormoduls verbunden ist;
ein zweiter Anschluss des dritten Magnetsensormoduls und ein zweiter Anschluss des vierten Magnetsensormoduls mit einer Energiequelle verbunden sind und ein elektrisches Signal zwischen einem zweiten Anschluss des ersten Magnetsensormoduls und einem zweiten Anschluss des zweiten Magnetsensormoduls ausgegeben wird;
die Nuten, die mit jedem Teil der Induktionseinheit gekoppelt sind, in einer ersten Seite des gekoppelten Teils der Induktionseinheit in dem ersten Magnetsensormodul angeordnet sind; eine anfängliche Magnetisierungsrichtung der Magnetmaterialschicht in der Induktionseinheit eine Richtung A ist und ein Strom eine Richtung B ist; die Nuten, die mit jedem Teil der Induktionseinheit gekoppelt sind, in einer zweiten Seite des gekoppelten Teils der Induktionseinheit in dem zweiten Magnetsensormodul angeordnet sind; eine anfängliche Magnetisierungsrichtung der Magnetmaterialschicht in der Induktionseinheit eine Richtung gleich der Richtung A ist und ein Strom eine Richtung parallelisiert zur Richtung B ist;
die Nuten, die mit jedem Teil der Induktionseinheit gekoppelt sind, in einer ersten Seite des gekoppelten Teils der Induktionseinheit in dem dritten Magnetsensormodul angeordnet sind; eine anfängliche Magnetisierungsrichtung der Magnetmaterialschicht in der Induktionseinheit eine Richtung gleich der Richtung A ist und ein Strom eine Richtung parallelisiert zur Richtung B ist;
die Nuten, die mit jedem Teil der Induktionseinheit gekoppelt sind, in einer zweiten Seite des gekoppelten Teils der Induktionseinheit in dem vierten Magnetsensormodul angeordnet sind; eine anfängliche Magnetisierungsrichtung der Magnetmaterialschicht in der Induktionseinheit eine Richtung gleich der Richtung A ist und ein Strom eine Richtung parallelisiert zur Richtung B ist.

7. Magnetsensorvorrichtung nach Anspruch 4 oder 5, wobei:
die Drittrichtungs-Magnetsensorkomponente ein erstes Magnetsensormodul, ein zweites Magnetsensormodul, ein drittes Magnetsensormodul und ein viertes Magnetsensormodul umfasst;
Mittelpunkte des ersten Magnetsensormoduls und des zweiten Magnetsensormoduls in der gleichen Linie liegen, das heißt Magnetisierungsrichtungen der Magnetmaterialschicht in der Induktionseinheit des ersten Magnetsensormoduls und des zweiten Magnetsensormoduls gleich oder entgegengesetzt sind und ein Verlauf der Nuten in den Magnetsensormodulen parallelisiert oder überlappt sind;
das dritte Magnetsensormodul und das vierte Magnetsensormodul entsprechend senkrecht zu dem ersten Magnetsensormodul und dem zweiten Magnetsensormodul sind, das heißt anfängliche Magnetisierungsrichtungen der Magnetmaterialschicht in der Induktionseinheit des dritten Magnetsensormoduls und des vierten Magnetsensormoduls entsprechend senkrecht zu dem ersten Magnetsensormodul und dem zweiten Magnetsensormodul sind und ein Verlauf der Nuten in dem dritten Magnetsensormodul und dem vierten Magnetsensormodul entsprechend senkrecht zu einem Verlauf der entsprechenden Nuten in dem ersten Magnetsensormodul und dem zweiten Magnetsensormodul sind;
ein erster Anschluss des ersten Magnetsensormoduls und ein erster Anschluss des zweiten Magnetsensormoduls erdend sind, ein zweiter Anschluss des ersten Magnetsensormoduls mit dem einem ersten Anschluss des vierten Magnetsensormoduls verbunden ist, ein zweiter Anschluss des zweiten Magnetsensormoduls mit dem einem ersten Anschluss des dritten Magnetsensormoduls verbunden ist; ein zweiter Anschluss des dritten Magnetsensormoduls und ein zweiter Anschluss des vierten Magnetsensormoduls mit einer Energiequelle verbunden sind und ein elektrisches Signal zwischen einem zweiten Anschluss des ersten Magnetsensormoduls und einem zweiten Anschluss des zweiten Magnetsensormoduls ausgegeben wird;
bezüglich des gekoppelten ersten Magnetsensormoduls und des zweiten Magnetsensormoduls die relative Position der Nut und der Induktionseinheiten für sie als entgegengesetzt eingestellt sind und im Rahmen der drei Faktoren die anfänglichen Magnetisierungsrichtungen und die Stromrichtungen als gleich eingestellt sind; oder die relative Position der Nut und der Induktionseinheiten für sie als entgegengesetzt eingestellt sind, die anfänglichen Magnetisierungsrichtungen als entgegengesetzt eingestellt sind und die Stromrichtungen senkrecht sind;
bezüglich des gekoppelten dritten Magnetsensormoduls und des vierten Magnetsensormoduls die relative Position der Nut und der Induktionseinheiten für sie als entgegengesetzt eingestellt sind und im Rahmen der drei Faktoren die anfänglichen Magnetisierungsrichtungen und Stromrichtungen als gleich eingestellt sind; oder die relative Position der Nut und der Induktionseinheiten für sie als entgegengesetzt eingestellt sind, die anfänglichen Magnetisierungsrichtungen als entgegengesetzt eingestellt sind und die Stromrichtungen senkrecht sind.

8. Magnetsensorvorrichtung nach Anspruch 1, wobei:
die Drittrichtungs-Magnetsensorkomponente eine periphere Schaltung umfasst, die zum Berechnen einer Magnetfeldstärke und Magnetfeldrichtung und zum Ausgeben benutzt wird;
ein Winkel zwischen einem Hauptteil der magnetischen leitfähigen Einheit und einer Oberfläche des Substrats 45°∼90° beträgt; die Induktionseinheit an die Oberfläche des Substrats gedrückt wird und zur Oberfläche des Substrats parallelisiert ist;
die erste Richtung eine X-Achse ist, die zweite Richtung eine Y-Achse ist und die dritte Richtung eine Z-Achse ist.

9. Magnetsensorvorrichtung nach Anspruch 1, wobei:
die Vorrichtung ferner eine zweite Magnetsensorkomponente umfasst, die zum Erfassen eines magnetischen Signals in der ersten Richtung oder/und der zweiten Richtung und Messen der entsprechenden Magnetfeldstärke und Magnetfeldrichtung in der ersten Richtung oder/und der zweiten Richtung damit benutzt wird.

10. Magnetsensorvorrichtung nach Anspruch 9, wobei:
die zweite Magnetsensorkomponente vier Induktionsuntereinheiten umfasst, die eine fünfte Induktionsuntereinheit, eine sechste Induktionsuntereinheit, eine siebte Induktionsuntereinheit und eine achte Induktionsuntereinheit sind;
wobei jede obige Induktionsuntereinheit eine Magnetmaterialschicht umfasst, wobei ein elektrischer Widerstand von magnetischem Material in der Magnetmaterialschicht in Abhängigkeit von der Magnetfeldstärke und -richtung veränderlich ist.

11. Magnetsensorvorrichtung nach einem der Ansprüche 1 bis 5, wobei:
die magnetische leitfähige Einheit und die Induktionseinheit entsprechend Magnetmaterialschichten umfassen; und
das Material der Magnetmaterialschicht ein Material mit Magnetowiderstand, Material mit anisotropem Magnetowiderstand (*anisotropic magneto-resistance* - AMR), Material mit Riesenmagnetowiderstand (*giant magneto-resistance* - GMR) oder Material mit Tunnelmagnetowiderstand (*tunneling magneto-resistance* - TMR) ist; wobei die Eigenschaft von ihnen AMR, GMR oder TMR ist.

12. Magnetinduktionsverfahren unter Benutzung der Magnetsensorvorrichtung nach einem der Ansprüche 1 bis 11, wobei das Verfahren Schritte eines Induzierens eines Magnetfelds in der dritten Richtung umfasst und konkret umfasst:
eine magnetische leitfähige Einheit erfasst ein magnetisches Signal in der dritten Richtung und gibt das magnetische Signal aus;
eine Induktionseinheit empfängt das magnetische Signal in der dritten Richtung, das durch die magnetische leitfähige Einheit ausgegeben wird, und misst anhand des magnetischen Signals die Magnetfeldstärke und Magnetfeldrichtung, die der dritten Richtung entsprechen; und
jedes Paar von Magnetsensormodulen kann das ausgegebene Magnetfeldsignal direkt in einer ersten oder/und zweiten Richtung des Paars von Magnetsensormodulen versetzen, nachdem die Installation jedes Paars von Magnetsensormodulen in der Magnetsensorvorrichtung abgeschlossen ist.

13. Magnetinduktionsverfahren nach Anspruch 12, wobei:
das Verfahren ferner den Induktionsschritt in einer ersten Richtung und zweiten Richtung umfasst und das magnetische Signal in der ersten Richtung und zweiten Richtung induziert und anhand von ihnen die Magnetfeldstärke und Magnetfeldrichtung misst, die der ersten Richtung und der zweiten Richtung entsprechen.

## Revendications

1. Dispositif de détection magnétique, dans lequel le dispositif comprend un composant de détection magnétique de troisième direction, le composant de détection magnétique de troisième direction comprend un substrat et une paire de modules de détection magnétique couplés, une rainure (11) est disposée dans une surface du substrat ; et chaque module de détection magnétique comprend :
une unité conductrice magnétique, dans lequel une partie principale de l'unité conductrice magnétique (20) est disposée dans la rainure et une partie de celle-ci est exposée à l'extérieur de la rainure et sur la surface du substrat, agencée afin de collecter un signal de champ magnétique dans la troisième direction et délivrer le signal de champ magnétique ; et
une unité d'induction (30,40) disposée sur la surface du substrat,
agencée pour recevoir le signal de champ magnétique dans la troisième direction et mesurer l'intensité de champ magnétique correspondante dans la troisième direction du signal de champ magnétique ;
dans lequel l'unité l'induction comprend une couche de matériau magnétique, une résistance magnétique du matériau magnétique dans la couche de matériau magnétique étant variable proportionnellement à l'intensité de champ magnétique et la direction ;
**caractérisé en ce que** le dispositif de détection est agencé de sorte que des signaux magnétiques de sortie dans une première direction et/ou dans une seconde direction pour chaque paire de module de détection magnétique couplés puissent être décalés, après que la paire correspondante de modules de détection magnétique couplés est installée ;
dans lequel le composant de détection magnétique de troisième direction comprend un premier module de détection magnétique, un second module de détection magnétique, un troisième module de détection magnétique et un quatrième module de détection magnétique, formant des paires de module de détection magnétique couplés ;
les deux modules de détection magnétique de chaque paire étant parallèles, de sorte que les directions de magnétisation initiale de la couche de matériau magnétique dans les unités d'induction des deux modules de détection magnétique sont identiques ou opposés, et les orientations des rainures dans les deux modules de détection magnétique sont parallèles ou superposés,
dans lequel une première borne du premier module de détection magnétique et une première borne du second module de détection magnétique sont connectées à la terre, une seconde borne du premier module de détection magnétique connecte à une première borne du quatrième module de détection magnétique, une seconde borne du second module de détection magnétique connecte à la première borne du troisième module de détection magnétique ; une seconde borne du troisième module de détection magnétique et une seconde borne du quatrième module de détection magnétique connecte à une source d'alimentation électrique et le dispositif de détection est configuré de sorte qu'un signal électrique soit émis entre la seconde borne du premier module de détection magnétique et la seconde borne du second module de détection magnétique ;
dans lequel les rainures couplées à chaque partie de l'unité d'induction sont disposée dans un premier côté de la partie couplée de l'unité d'induction dans le premier module de détection magnétique ; une direction de magnétisation initiale de la couche de matériau magnétique dans l'unité d'induction est la direction A et le courant est la direction B ;
dans lequel les rainures couplées à chaque partie de l'unité d'induction sont disposées dans un second côté de la partie couplée de l'unité d'induction dans le second module de détection magnétique ; une direction de magnétisation initiale de la couche de matériau magnétique dans l'unité d'induction est une direction opposée à la direction A et le courant est une direction perpendiculaire à la direction B;
dans lequel les rainures couplées à chaque partie de l'unité d'induction sont disposées dans un premier côté de la partie couplée de l'unité d'induction dans le troisième module de détection magnétique ;
le dispositif de détection est configuré de sorte qu'une direction de magnétisation initiale de la couche de matériau magnétique dans l'unité d'induction est dans une direction parallèle à la direction A et un courant est dans une direction parallèle à la direction B ;
dans lequel les rainures couplées à chaque partie de l'unité d'induction sont disposées dans un second côté de la partie couplée de l'unité d'induction dans le quatrième module de détection magnétique ; le dispositif de détection est configuré de sorte que la direction de magnétisation initiale de la couche de matériau magnétique dans l'unité d'induction est dans une direction opposée à la direction A et le courant est dans une direction perpendiculaire à la direction B ;
dans lequel chaque unité conductrice magnétique comprend quatre sous unités conductrices magnétiques, qui sont une première sous unité conductrice magnétique, une seconde sous unité conductrice magnétique, une troisième sous unité conductrice magnétique et une quatrième sous unité conductrice magnétique ;
dans lequel chaque unité d'induction comprend quatre sous unités d'induction, qui sont une première sous unité d'induction, une seconde sous unité d'induction, une troisième sous unité d'induction et une quatrième sous unité d'induction ;
dans lequel la première sous unité conductrice magnétique est couplée avec la première sous unité d'induction comme le premier module d'induction du composant de détection magnétique dans la troisième direction ;
dans lequel la seconde sous unité conductrice magnétique est couplée avec la seconde sous unité d'induction comme le second module d'induction du composant d'induction magnétique dans la troisième direction ;
dans lequel la troisième sous unité conductrice magnétique est couplée avec la troisième sous unité d'induction comme le troisième module d'induction du composant d'induction magnétique dans la troisième direction ;
dans lequel la quatrième sous unité conductrice magnétique est couplée avec la quatrième sous unité d'induction comme le quatrième module d'induction du composant de détection magnétique dans la troisième direction ;
dans lequel chaque unité d'induction comprend une couche de matériau magnétique, une résistance électrique du matériau magnétique dans la couche de matériau magnétique étant variable en fonction de l'intensité de champ magnétique et la direction ;
dans lequel une ou plusieurs colonnes de rainures sont disposées dans le substrat et une colonne de rainures est formée par une longue rainure, ou une colonne de rainures comprend des sous rainures multiples ;
dans lequel chaque sous unité conductrice magnétique comprend des accessoires magnétiques multiples, une partie principale de l'accessoire magnétique étant disposée dans la rainure correspondante et une partie de celui-ci étant exposé hors de la rainure ; et la partie exposée étant pressée sur la couche de matériau magnétique de la sous unité d'induction correspondante ;
dans lequel chaque accessoire magnétique à la partie exposée en dehors de la rainure et la distance entre la partie exposée et la couche de matériau magnétique de la sous unité d'induction correspondante est 0-20 micromètre ; et
dans lequel chaque unité conductrice magnétique et la couche de matériau magnétique de chaque unité d'induction ont été formée par le même matériau magnétique et ont le même nombre de couches qui ont été déposées dans la même étape ;
ou chaque unité conductrice magnétique et la couche de matériau magnétique de chaque unité d'induction ont été formées par des matériaux magnétiques différents déposés dans des étapes différentes.

2. Dispositif de détection magnétique selon la revendication 1, dans lequel :
le composant de détection magnétique de troisième direction est un composant de détection magnétique de direction perpendiculaire ;
l'unité conductrice magnétique est utilisée pour collecter le signal de champ magnétique dans la direction perpendiculaire et délivrer le signal magnétique ;
l'unité d'induction est un champ magnétique d'induction de capteur magnétique parallèle à la surface du substrat, disposé sur la surface du substrat, utilisé pour recevoir le signal de champ magnétique dans la direction perpendiculaire émis par l'unité conductrice magnétique et mesurant une intensité de champ magnétique correspondante dans la direction perpendiculaire par le signal de champ magnétique ; et
le dispositif de détection magnétique comprend en outre un premier capteur magnétique et un second capteur magnétique agencés pour induire des champs magnétiques dans la première direction et la seconde direction respectivement ; et la première direction et la seconde direction sont perpendiculaires.

3. Dispositif de détection magnétique selon la revendication 1, dans lequel :
le dispositif de détection magnétique comprend un premier capteur magnétique et un second capteur magnétique agencés pour induire un champ magnétique dans la première direction et la seconde direction respectivement ; et la première direction, la seconde direction et la troisième direction sont perpendiculaires l'une à l'autre.

4. Dispositif de détection magnétique selon la revendication 1, dans lequel :
chaque paire de modules de détection magnétique couplés comprend trois facteurs :
(1) les emplacements relatifs de la rainure et l'unité d'induction ; la rainure disposée dans un côté de l'unité d'induction correspondante ou l'autre côté ; l'unité conductrice magnétique est à gauche de l'unité d'induction afin de guider le champ magnétique dans la troisième direction vers une direction dans la surface du substrat et l'unité conductrice magnétique est à droite de l'unité d'induction, afin de guider le champ magnétique dans la troisième direction vers une autre direction dans la surface du substrat ;
(2) l'unité d'induction adopte une direction de magnétisation initiale par excitation extérieure du champ magnétique ; et les directions de magnétisation initiale des deux modules de détection magnétique sont réglées comme identiques ou opposées et
(3) la direction du courant dans le module de détection magnétique ;
les directions du courant dans les deux modules de détection magnétique sont réglées comme identiques ou opposées ;
pour chacun des deux modules de détection magnétique couplés, les premiers facteurs dans les trois facteurs sont réglés comme opposés et les deux autres sont réglés comme identiques ; ou tous les facteurs sont réglés comme opposés ;
une comparaison des deux modules de détection magnétique ci-dessus est basée sur les deux modules de détection magnétique parallèles.

5. Dispositif de détection magnétique selon la revendication 4, dans lequel :
chaque module de détection magnétique est parallèle, et les premiers facteurs sont réglés comme opposés et les deux autres facteurs sont réglés comme identiques pour les trois facteurs des deux modules de détection magnétique connectés ; ou tous les facteurs sont réglés comme opposés.

6. Dispositif de détection magnétique selon une quelconque des revendications 1 à 5, dans lequel :
le composant de détection magnétique de troisième direction comprend un premier module de détection magnétique, un second module de détection magnétique, un troisième module de détection magnétique et un quatrième module de détection magnétique ;
chaque module de détection magnétique ci-dessus est parallèle, c'est-à-dire que les directions de magnétisation initiale de la couche de matériau magnétique dans l'unité d'induction des deux modules de détection magnétique sont identiques ou opposées et les orientations des rainures dans les deux modules de détection magnétique sont parallèles ou superposées,
une première borne du premier module de détection magnétique et une première borne du second module de détection magnétique sont connectées à la terre, une seconde borne du premier module de détection magnétique connecte à une première borne du quatrième module de détection magnétique, une seconde borne du second module de détection magnétique connecte à la première borne du troisième module de détection magnétique ; une seconde borne du troisième module de détection magnétique et une seconde borne du quatrième module de détection magnétique connecte à une source d'alimentation électrique et un signal électrique est émis entre la seconde borne du premier module de détection magnétique et la seconde borne du second module de détection magnétique ;
les rainures couplées à chaque partie de l'unité d'induction sont disposée dans un premier côté de la partie couplée de l'unité d'induction dans le premier module de détection magnétique ; une direction de magnétisation initiale de la couche de matériau magnétique dans l'unité d'induction est la direction A et le courant est la direction B ;
les rainures couplées à chaque partie de l'unité d'induction sont disposées dans un second côté de la partie couplée de l'unité d'induction dans le second module de détection magnétique ; une direction de magnétisation initiale de la couche de matériau magnétique dans l'unité d'induction est une direction opposée à la direction A et le courant est une direction perpendiculaire à la direction B;
les rainures couplées à chaque partie de l'unité d'induction sont disposées dans un premier côté de la partie couplée de l'unité d'induction dans le troisième module de détection magnétique ; une direction de magnétisation initiale de la couche de matériau magnétique dans l'unité d'induction est dans une direction parallèle à la direction A et un courant est dans une direction parallèle à la direction B ;
les rainures couplées à chaque partie de l'unité d'induction sont disposées dans un second côté de la partie couplée de l'unité d'induction dans le quatrième module de détection magnétique ; le dispositif de détection est configuré de sorte que la direction de magnétisation initiale de la couche de matériau magnétique dans l'unité d'induction est dans une direction opposée à la direction A et le courant est dans une direction perpendiculaire à la direction B.

7. Dispositif de détection magnétique selon la revendication 4 ou 5, dans lequel :
le composant de détection magnétique de troisième direction comprend un premier module de détection magnétique, un second module de détection magnétique, un troisième module de détection magnétique et un quatrième module de détection magnétique ;
les points centraux du premier module de détection magnétique du second module de détection magnétique sont dans la même ligne, c'est-à-dire que les directions de magnétisation de la couche de matériau magnétique dans l'unité d'induction du premier module de détection magnétique et du second module de détection magnétique sont identiques ou opposées et les orientations des rainures dans les modules de détection magnétique sont parallèles ou superposées ;
le troisième module de détection magnétique et le quatrième module de détection magnétique sont respectivement perpendiculaires au premier module de détection magnétique et au second module de détection magnétique, c'est-à-dire que les directions de magnétisation initiale de la couche de matériau magnétique dans l'unité d'induction du troisième module de détection magnétique et du quatrième module de détection magnétique sont respectivement perpendiculaires au premier module de détection magnétique et au second module de détection magnétique et les orientations des rainures dans le troisième module de détection magnétique et le quatrième module de détection magnétique sont respectivement perpendiculaires à l'orientation des rainures correspondantes dans le premier module de détection magnétique et le second module de détection magnétique ;
une première borne du premier module de détection magnétique et une première borne du second module de détection magnétique sont connectés à la terre, une seconde borne du premier module de détection magnétique connecte à une première borne du quatrième module de détection magnétique, une seconde borne du second module de détection magnétique connecte à une première borne du troisième module de détection magnétique ;
une seconde borne du troisième module de détection magnétique et une seconde borne du quatrième module de détection médiatique connecte à une source d'alimentation électrique et un signal électrique est émis entre une seconde borne du premier module de détection et une seconde borne du second module de détection magnétique ;
pour le premier module de détection magnétique et le second module de détection magnétique couplé, l'emplacement relatif de la rainure et des unités d'induction sont réglés comme opposés et les directions de médiatisation et signal et les directions de courant sont réglées comme identiques dans les trois facteurs ; ou l'emplacement relatif de la rainure et des unités d'induction sont réglées comme opposés, les directions de magnétisation initiale réglées comme opposées et les directions de courant sont perpendiculaires ;
pour le troisième module de détection magnétique et le quatrième module de détection magnétique couplés, l'emplacement relatif de la rainure et des unités d'induction sont réglées comme opposés et les directions de magnétisation initiale et les directions de courant sont réglées comme identiques dans les trois facteurs ; ou l'emplacement relatif de la rainure et des unités d'induction sont réglées comme opposés, les directions de magnétisation initiale réglées comme opposées et les directions de courant sont perpendiculaires.

8. Dispositif de détection magnétique selon la revendication 1, dans lequel :
le composant de détection magnétique de troisième direction comprend un circuit périphérique, utilisé pour calculer une intensité de champ magnétique et une direction de champ magnétique et émettre ;
un angle entre une partie principale de l'unité conductrice magnétique et la surface du substrat est 45°∼90° ; l'unité d'induction est pressée sur la surface du substrat et parallèle à la surface du substrat ;
la première direction est l'axe X, la seconde direction est l'axe Y et la troisième direction est l'axe Z.

9. Dispositif de détection magnétique selon la revendication 1, dans lequel :
le dispositif comprend en outre un second composant de détection magnétique, utilisé pour détecter un signal magnétique dans la première direction et/ou dans la seconde direction et mesurer l'intensité de champ magnétique et la direction de champ magnétique correspondante dans la première direction et/ou dans la seconde direction.

10. Dispositif de détection magnétique selon la revendication 9, dans lequel :
le second composant de détection magnétique comprend quatre sous unité d'induction, qui sont une cinquième sous unité d'induction, une sixième sous unité d'induction, une septième sous unité d'induction et une huitième sous unité d'induction ;
chaque sous unité d'induction ci-dessus comprend une couche de matériau magnétique, une résistance électrique du matériau magnétique dans la couche de matériau magnétique variable en fonction de l'intensité et la direction de champ magnétique.

11. Dispositif de détection magnétique selon une quelconque des revendications 1 à 5, dans lequel :
l'unité conductrice magnétique et l'unité d'induction comprennent des couches de matériau magnétique respectivement ; et
le matériau de la couche de matériau magnétique est un matériau de magnétorésistance, un matériau de magnétorésistance anisotropique (AMR), un matériau de magnétorésistance géante (GMR) ou un matériau de magnétorésistance de tunnelisation (TMR) ; dans lequel leur caractère est AMR, GMR ou TMR.

12. Procédé d'induction magnétique utilisant le dispositif de détection magnétique décrit dans une quelconque des revendications, 1 à 11, dans lequel le procédé comprend les étapes d'induction d'un champ magnétique dans la troisième direction et comprend spécifiquement :
une unité conductrice magnétique collecte le signal magnétique dans la troisième direction et émet le signal magnétique ;
une unité d'induction reçoit le signal magnétique dans la troisième direction par l'unité conductrice magnétique et mesure l'intensité de champ magnétique et la direction de champ magnétique correspondant à la troisième direction par le signal magnétique ; et
chaque paire de modules de détection magnétique peut directement décaler le signal de champ magnétique émis dans la première et/ou deuxième direction de la paire de modules de détection magnétique, après que l'installation de chaque paire de module de détection magnétique dans le dispositif de détection magnétique est terminée.

13. Procédé d'induction magnétique selon la revendication 12, dans lequel :
le procédé comprend en outre l'étape d'induction dans la première direction à la seconde direction et d'induire le signal magnétique dans la première direction et la seconde direction et mesurer l'intensité de champ magnétique et la direction de champ magnétique correspondant à la première direction et la seconde direction par celles-ci.
